# EUROPEAN PATENT APPLICATION

(11) **EP 4 467 691 A1**
(43) Date of publication of application: **27.11.2024**
(21) Application number: 22921916.7
(22) Date of filing: 21.01.2022
(51) Int. Cl.: C30B 33/00, C30B 29/40, C30B 29/42, C30B 33/08, H01L 21/304

(54) **GROUP III-V COMPOUND SEMICONDUCTOR SINGLE CRYSTAL SUBSTRATE AND PRODUCTION METHOD THEREFOR**

(71) Applicant: SUMITOMO ELECTRIC INDUSTRIES, LTD., Osaka-shi, Osaka 541-0041 (JP)
(72) Inventor: NODA, Kazuki, Kobe-shi, Hyogo 651-2271 (JP); UEMATSU, Koji, Kobe-shi, Hyogo 651-2271 (JP); NAKANISHI, Fumitake, Kobe-shi, Hyogo 651-2271 (JP)
(74) Representative: Grünecker Patent- und Rechtsanwälte PartG mbB
(86) International application number: PCT/JP2022/002223
(87) International publication number: WO 2023/139759

(57) **Abstract**

The group III-V compound semiconductor single crystal substrate has a circular main surface, wherein the main surface has an orientation flat or a notch and has a first region that is inside a first virtual line passing through a point 5 mm away inward from an outer periphery thereof, and a first reference line that is a virtual line segment extending from a center of the main surface to the first virtual line in a direction going from the center of the main surface toward the orientation flat or the notch; on the main surface, the number of particles having a particle size of 0.079 µm or more at each of measurement points at nine points in total is measured, where the nine points are one point at the center, four midpoints of four virtual line segments having angles of 0 degrees, 90 degrees, 180 degrees, and 270 degrees, respectively, with respect to the first reference line and extending from the center to the first virtual line, and four endpoints of four virtual line segments having angles of 45 degrees, 135 degrees, 225 degrees, and 315 degrees, respectively, with respect to the first reference line and extending from the center to the first virtual line, and a standard deviation and an average value of the number of the particles calculated based on the measurement satisfy a relationship of standard deviation/average value ≤ 0.9.

## Description

### TECHNICAL FIELD

The present disclosure relates to a group III-V compound semiconductor single crystal substrate and a method for manufacturing the same.

### BACKGROUND ART

A group III-V compound semiconductor single crystal substrate such as an indium phosphide single crystal substrate or a gallium arsenide single crystal substrate is suitably used as a substrate for a semiconductor device. It is conventionally known that a high-performance semiconductor device can be obtained by growing a high-quality epitaxial layer on the main surface of a group III-V compound semiconductor single crystal substrate. The high-quality epitaxial layer means an epitaxial layer having few or no defects. A high-quality epitaxial layer can be grown when there are few impurities on the main surface, that is, when the main surface is clean. Because of this, the group III-V compound semiconductor single crystal substrate is required to have a clean main surface. WO 2018/216440 (Patent Literature 1) proposes a group III-V compound semiconductor single crystal substrate having a clean main surface in response to the above requirement.

### CITATION LIST

### PATENT LITERATURE

PTL 1: WO 2018/216440

### SUMMARY OF INVENTION

The group III-V compound semiconductor single crystal substrate according to the present disclosure is a group III-V compound semiconductor single crystal substrate having a circular main surface, wherein the main surface has an orientation flat or a notch; the main surface has a first region that is a circular region inside a first virtual line passing through a point 5 mm away inward from an outer periphery thereof, and a first reference line that is a virtual line segment extending from a center of the main surface to the first virtual line in a direction going from the center of the main surface toward the orientation flat or the notch; on the main surface, the number of particles having a particle size of 0.079 µm or more at each of measurement points at nine points in total is measured, where the nine points are one point at the center, four midpoints of four virtual line segments having angles of 0 degrees, 90 degrees, 180 degrees, and 270 degrees, respectively, with respect to the first reference line and extending from the center to the first virtual line, and four endpoints of four virtual line segments having angles of 45 degrees, 135 degrees, 225 degrees, and 315 degrees, respectively, with respect to the first reference line and extending from the center to the first virtual line, and a standard deviation and an average value of the number of the particles calculated based on measurement results thereof satisfy a relationship of standard deviation/average value ≤ 0.9; and in the first region, a density of the particles having a particle size of 0.079 µm or more is 0 /cm² or more and 13.0 /cm² or less.

The group III-V compound semiconductor single crystal substrate according to the present disclosure is a group III-V compound semiconductor single crystal substrate having a circular main surface, wherein the group III-V compound semiconductor single crystal substrate is an indium phosphide single crystal substrate; the main surface has an orientation flat or a notch; the main surface has a first region that is a circular region inside a first virtual line passing through a point 5 mm away inward from an outer periphery thereof, and a first reference line that is a virtual line segment extending from a center of the main surface to the first virtual line in a direction going from the center of the main surface toward the orientation flat or the notch; on the main surface, the number of particles having a particle size of 0.19 µm or more at each of measurement points at nine points in total is measured, where the nine points are one point at the center, four midpoints of four virtual line segments having angles of 0 degrees, 90 degrees, 180 degrees, and 270 degrees, respectively, with respect to the first reference line and extending from the center to the first virtual line, and four endpoints of four virtual line segments having angles of 45 degrees, 135 degrees, 225 degrees, and 315 degrees, respectively, with respect to the first reference line and extending from the center to the first virtual line, and a standard deviation and an average value of the number of the particles calculated based on measurement results thereof satisfy a relationship of standard deviation/average value ≤ 1.25; and in the first region, a density of the particles having a particle size of 0.19 µm or more is 0 /cm² or more and 0.62 /cm² or less.

The method for manufacturing a group III-V compound semiconductor single crystal substrate according to the present disclosure includes a cleaning step for obtaining a group III-V compound semiconductor single crystal substrate having a circular main surface from a group III-V compound semiconductor single crystal substrate precursor, wherein the cleaning step includes following steps in order of: a liquid phase treating step of cleaning the group III-V compound semiconductor single crystal substrate precursor with a liquid phase, a vapor phase treating step of cleaning the group III-V compound semiconductor single crystal substrate precursor with a vapor phase, and an oxide film removing step of removing an oxide film attached to the group III-V compound semiconductor single crystal substrate precursor, the vapor phase treating step includes irradiating the group III-V compound semiconductor single crystal substrate precursor with ultraviolet radiation in an ozone atmosphere or in an oxygen-containing atmosphere, and the oxide film removing step includes removing the oxide film with a first solution including hydrofluoric acid at 0.1% by mass or more.

### BRIEF DESCRIPTION OF DRAWINGS

Fig. 1 is an illustrative diagram for describing the positions of measurement points at nine points on the main surface (first region) of a group III-V compound semiconductor single crystal substrate having an orientation flat, used for measuring the number of particles.
Fig. 2 is an illustrative diagram for describing the positions of measurement points at nine points on the main surface (first region) of a group III-V compound semiconductor single crystal substrate having a notch, used for measuring the number of particles.
Fig. 3 is a flow chart showing an example of a method for manufacturing a group III-V compound semiconductor single crystal substrate according to the present embodiment.

### DETAILED DESCRIPTION

### [Problem to be Solved by the Present Disclosure]

The group III-V compound semiconductor single crystal substrate of Patent Literature 1 has a clean main surface, but in the technical field related to the substrate, there is a case where a stricter condition for the cleanness of the main surface is required. Specifically, in order to contribute to much higher performance of a semiconductor device, it has been requested, for example, that the density of particles on the main surface of the group III-V compound semiconductor single crystal substrate be further reduced, and that the number of particles be small regardless of the central portion or the outer periphery on the main surface (that is, the number of particles be uniformly small on the main surface). In this case, the group III-V compound semiconductor single crystal substrate of Patent Literature 1 has room for improvement from the viewpoint of the cleanness.

In view of the above circumstances, an object of the present disclosure is to provide a group III-V compound semiconductor single crystal substrate in which the density of particles on the main surface is reduced and the number of particles is uniformly small on the main surface.

### [Advantageous Effect of the Present Disclosure]

According to the present disclosure, it is possible to provide a group III-V compound semiconductor single crystal substrate in which the density of particles on the main surface is reduced and the number of particles is uniformly small on the main surface.

### [Outline of Embodiment]

First, an outline of an embodiment of the present disclosure will be described. The present inventors have carried out intensive studies to solve the above problem, and completed the present disclosure. Specifically, regarding the cleaning step carried out in the process of obtaining a group III-V compound semiconductor single crystal substrate from a group III-V compound semiconductor single crystal (hereinafter also referred to as a "group III-V compound semiconductor single crystal substrate precursor"), the present inventors have paid attention to carrying out a vapor phase treatment involving carrying out ultraviolet irradiation in an ozone atmosphere or an oxygen atmosphere in addition to the conventional liquid phase treatment that uses both or one of an acidic solution and an alkaline solution. The present inventors have found that thereby, fine particles (especially organic components) present on the main surface of the group III-V compound semiconductor single crystal substrate precursor can be removed, and the density of particles on the main surface can be further reduced. In addition, the fine particles are unevenly distributed on the outer periphery of the main surface, and thus the number of particles on the main surface can be uniformly reduced regardless of the central portion and the outer periphery by the vapor phase treatment, and the present inventors have arrived at the present disclosure.

### .

Next, embodiments of the present disclosure will be listed and described.
[1] The group III-V compound semiconductor single crystal substrate according to an embodiment of the present disclosure is a group III-V compound semiconductor single crystal substrate having a circular main surface, wherein the main surface has an orientation flat or a notch; the main surface has a first region that is a circular region inside a first virtual line passing through a point 5 mm away inward from an outer periphery thereof, and a first reference line that is a virtual line segment extending from a center of the main surface to the first virtual line in a direction going from the center of the main surface toward the orientation flat or the notch; on the main surface, the number of particles having a particle size of 0.079 µm or more at each of measurement points at nine points in total is measured, where the nine points are one point at the center, four midpoints of four virtual line segments having angles of 0 degrees, 90 degrees, 180 degrees, and 270 degrees, respectively, with respect to the first reference line and extending from the center to the first virtual line, and four endpoints of four virtual line segments having angles of 45 degrees, 135 degrees, 225 degrees, and 315 degrees, respectively, with respect to the first reference line and extending from the center to the first virtual line, and a standard deviation and an average value of the number of the particles calculated based on measurement results thereof satisfy a relationship of standard deviation/average value ≤ 0.9; and in the first region, a density of the particles having a particle size of 0.079 µm or more is 0 /cm² or more and 13.0 /cm² or less. In a group III-V compound semiconductor single crystal substrate having such characteristics, the density of particles on the main surface can be reduced, and the number of particles can be uniformly reduced on the main surface.
[2] The group III-V compound semiconductor single crystal substrate according to an embodiment of the present disclosure is a group III-V compound semiconductor single crystal substrate having a circular main surface, wherein the group III-V compound semiconductor single crystal substrate is an indium phosphide single crystal substrate; the main surface has an orientation flat or a notch; the main surface has a first region that is a circular region inside a first virtual line passing through a point 5 mm away inward from an outer periphery thereof, and a first reference line that is a virtual line segment extending from a center of the main surface to the first virtual line in a direction going from the center of the main surface toward the orientation flat or the notch; on the main surface, the number of particles having a particle size of 0.19 µm or more at each of measurement points at nine points in total is measured, where the nine points are one point at the center, four midpoints of four virtual line segments having angles of 0 degrees, 90 degrees, 180 degrees, and 270 degrees, respectively, with respect to the first reference line and extending from the center to the first virtual line, and four endpoints of four virtual line segments having angles of 45 degrees, 135 degrees, 225 degrees, and 315 degrees, respectively, with respect to the first reference line and extending from the center to the first virtual line, and a standard deviation and an average value of the number of the particles calculated based on measurement results thereof satisfy a relationship of standard deviation/average value ≤ 1.25; and in the first region, a density of the particles having a particle size of 0.19 µm or more is 0 /cm² or more and 0.62 /cm² or less. In a group III-V compound semiconductor single crystal substrate having such characteristics, the density of particles on the main surface can be reduced, and the number of particles can be uniformly reduced on the main surface.
[3] The group III-V compound semiconductor single crystal substrate is preferably an indium phosphide single crystal substrate. This can provide an indium phosphide single crystal substrate in which the density of particles on the main surface is reduced and the number of particles is uniformly small on the main surface.
[4] In the indium phosphide single crystal substrate, the standard deviation and the average value of the number of the particles having a particle size of 0.079 µm or more satisfy the relationship of 0.23 ≤ standard deviation/average value ≤ 0.71, and the density of the particles having a particle size of 0.079 µm or more is 2.2 /cm² or more and 12.3 /cm² or less. This can provide, with a good yield, an indium phosphide single crystal substrate in which the density of particles on the main surface is reduced and the number of particles is uniformly small on the main surface.
[5] In the indium phosphide single crystal substrate, the diameter of the main surface is preferably 75 mm or more and 155 mm or less. As described later, in the present disclosure, a large substrate in which the diameter of the main surface has a size of 75 mm or more and 155 mm or less can be applied to the indium phosphide single crystal substrate. This can reduce the density of particles on the main surface of a large indium phosphide single crystal substrate having a diameter of 75 mm or more and 155 mm or less, and uniformly reduce the number of particles on the main surface.
[6] The group III-V compound semiconductor single crystal substrate is preferably a gallium arsenide single crystal substrate. This can provide a gallium arsenide single crystal substrate in which the density of particles on the main surface is reduced and the number of particles is uniformly small on the main surface.
[7] In the gallium arsenide single crystal substrate, preferably the standard deviation and the average value of the number of the particles having a particle size of 0.079 µm or more satisfy the relationship of 0.5 ≤ standard deviation/average value ≤ 0.89, and the density of the particles having a particle size of 0.079 µm or more is 0.5 /cm² or more and 2.7 /cm² or less. This can provide, with a good yield, a gallium arsenide single crystal substrate in which the density of particles on the main surface is reduced and the number of particles is uniformly small on the main surface.
[8] In the gallium arsenide single crystal substrate, the diameter of the main surface is preferably 75 mm or more and 205 mm or less. As described later, in the present disclosure, a large substrate in which the diameter of the main surface has a size of 75 mm or more and 205 mm or less can be applied to the gallium arsenide single crystal substrate. This can reduce the density of particles on the main surface of a large gallium arsenide single crystal substrate having a diameter of 75 mm or more and 205 mm or less, and uniformly reduce the number of particles on the main surface.
[9] Furthermore, one aspect of the present disclosure is a method for manufacturing a group III-V compound semiconductor single crystal substrate, the method including a cleaning step for obtaining a group III-V compound semiconductor single crystal substrate having a circular main surface from a group III-V compound semiconductor single crystal substrate precursor, wherein the cleaning step includes following steps in order of: a liquid phase treating step of cleaning the group III-V compound semiconductor single crystal substrate precursor with a liquid phase, a vapor phase treating step of cleaning the group III-V compound semiconductor single crystal substrate precursor with a vapor phase, and an oxide film removing step of removing an oxide film attached to the group III-V compound semiconductor single crystal substrate precursor, the vapor phase treating step includes irradiating the group III-V compound semiconductor single crystal substrate precursor with ultraviolet radiation in an ozone atmosphere or in an oxygen-containing atmosphere, and the oxide film removing step includes removing the oxide film with a first solution including hydrofluoric acid at 0.1% by mass or more. A method for manufacturing a group III-V compound semiconductor single-crystal substrate having such characteristics can yield a group III-V compound semiconductor single crystal substrate in which the density of particles on the main surface is reduced and the number of particles is uniformly small on the main surface.
[10] The first solution preferably further includes ammonium fluoride. This makes it possible to manufacture, with a good yield, a group III-V compound semiconductor single crystal substrate in which the density of particles on the main surface is reduced and the number of particles is uniformly small on the main surface.
[11] The irradiating with ultraviolet radiation is preferably carried out under conditions of 25°C or more and 150°C or less and 1 minute or more and 60 minutes or less. This makes it possible to manufacture, with a good yield, a group III-V compound semiconductor single crystal substrate in which the density of particles on the main surface is reduced and the number of particles is uniformly small on the main surface.
[12] The group III-V compound semiconductor single crystal substrate is preferably an indium phosphide single crystal substrate. This makes it possible to manufacture an indium phosphide single crystal substrate in which the density of particles on the main surface is reduced and the number of particles is uniformly small on the main surface.
[13] The group III-V compound semiconductor single crystal substrate is preferably a gallium arsenide single crystal substrate. This makes it possible to manufacture a gallium arsenide single crystal substrate in which the density of particles on the main surface is reduced and the number of particles is uniformly small on the main surface.

### [Details of Embodiment]

Hereinafter, an embodiment according to the present disclosure (hereinafter also referred to as "the present embodiment") will be described in further detail, but the present disclosure is not limited thereto. The following description may be made with reference to a drawing, and an identical or corresponding element in the present specification and the drawing is denoted by the same reference sign, and the same description thereof will not be repeated.

As used herein, the expression of a range in the format "A to B" means the upper limit and the lower limit of the range (that is, A or more and B or less), and when no unit is written in A and a unit is only written in B, the unit for A and the unit for B are the same. Furthermore, as used herein, when a compound or the like is represented by a chemical formula, if the atomic ratio is not particularly limited, the chemical formula shall include all conventionally known atomic ratios, and should not necessarily be limited only to those within the stoichiometric range.

Herein, the group III-V compound semiconductor single crystal substrate has a "circular" main surface. The "circular" includes a shape in which the main surface does not form a geometric circular shape because of forming at least one of an orientation flat (hereinafter also referred to as an "OF") or a notch. In other words, herein, the main surface shall be "circular" in shape based on the shape before the OF or the notch is formed. In addition, the "circular" also includes a shape in which the main surface does not form a geometric circular shape because of the shape of a group III-V compound semiconductor single crystal before cut as the group III-V compound semiconductor single crystal substrate.

Furthermore, the "main surface" of the group III-V compound semiconductor single crystal substrate means both of the two circular surfaces of the substrate. When at least one of these two surfaces satisfies the Claims of the present disclosure, such a group III-V compound semiconductor single crystal substrate falls within the scope of the present invention. Furthermore, when the diameter of the main surface of the group III-V compound semiconductor single crystal substrate is written as "75 mm," it means that the diameter is around 75 mm (about 75 to 76.5 mm) or 3 inches. When the diameter is written as "100 mm," it means that the diameter is around 100 mm (about 95 to 105 mm) or 4 inches. When the diameter is written as "150 mm," it means that the diameter is around 150 mm (about 145 to 155 mm) or 6 inches. When the diameter is written as "200 mm," it means that the diameter is around 200 mm (about 195 to 205 mm) or 8 inches. Here, the main surface does not show a geometric circular shape because of the influence of the OF, notch, or the like formed thereon, but the diameter (size) of the main surface is determined based on the circular shape before the OF, notch, or the like is formed. The diameter of the main surface can be measured by using a conventionally known outer diameter measuring instrument such as vernier calipers.

In the crystallographic description herein, an individual orientation is indicated by [], a family of orientations are indicated by <>, an individual plane is indicated by (), and a family of planes are indicated by {}. In addition, a crystallographic index that is negative is usually expressed by adding a "-" (bar) above the number, but herein, a negative sign is added in front of the number.

### [Group III-V Compound Semiconductor Single Crystal Substrate (First Embodiment)]

The group III-V compound semiconductor single crystal substrate according to the present embodiment is a group III-V compound semiconductor single crystal substrate having a circular main surface. The main surface has an orientation flat or a notch. The main surface has a first region that is a circular region inside a first virtual line passing through a point 5 mm away inward from the outer periphery thereof, and a first reference line that is a virtual line segment extending from the center of the main surface to the first virtual line in a direction going from the center of the main surface toward the orientation flat or the notch.

On the main surface, the number of particles having a particle size of 0.079 µm or more at each of measurement points at nine points in total is measured, where the nine points are one point at the center, four midpoints of four virtual line segments having angles of 0 degrees, 90 degrees, 180 degrees, and 270 degrees, respectively, with respect to the first reference line and extending from the center to the first virtual line, and four endpoints of four virtual line segments having angles of 45 degrees, 135 degrees, 225 degrees, and 315 degrees, respectively, with respect to the first reference line and extending from the center to the first virtual line, and the standard deviation and the average value of the number of the particles calculated based on measurement results thereof satisfy the relationship of standard deviation/average value ≤ 0.9. Furthermore, in the first region, the density of the particles having a particle size of 0.079 µm or more is 0 /cm² or more and 13.0 /cm² or less.

In a group III-V compound semiconductor single crystal substrate having such characteristics, the density of particles having a particle size of 0.079 m or more on the main surface (first region) is as low as 0 /cm² or more and 13.0 /cm² or less, and the density of particles on the main surface can be reduced as compared with the conventional one. Furthermore, in the group III-V compound semiconductor single crystal substrate, the number of the particles having a particle size of 0.079 µm or more is measured at each of the measurement points at the nine points described above, and the standard deviation and the average value of the number of the particles calculated based on the measurement results thereof satisfy the relationship of standard deviation/average value ≤ 0.9. This can uniformly reduce the number of particles on the main surface. Therefore, the group III-V compound semiconductor single crystal substrate according to the present embodiment can grow a high-quality epitaxial layer on the main surface, thereby making it possible to provide a high-performance semiconductor device.

Here, as used herein, the "particle" refers to a fine particle (especially an organic component) attached to the main surface of the group III-V compound semiconductor single crystal substrate. The number of particles having a particle size of 0.079 m or more (hereinafter also referred to as "first particles") can be evaluated by detecting the number of light scattering bright spots observed on the main surface under a light collecting lamp in a dark chamber. Furthermore, the "particle size" of a particle means the diameter of a circle that is equal in area to the particle measured as the light scattering bright spot.

As used herein, the "epitaxial layer" refers to a layer formed by epitaxial growth on the main surface of the group III-V compound semiconductor single crystal substrate. The epitaxial layer should not be particularly limited, and the epitaxial layer is preferably a group III-V compound semiconductor single crystal layer from the viewpoint of growing a high-quality epitaxial layer. Examples of the composition of the group III-V compound semiconductor single crystal layer include a composition including a group 13 element such as Al (aluminum), Ga (gallium), or In (indium), and a group 15 element such as N (nitrogen), P (phosphorus), or As (arsenic). Examples of the group III-V compound semiconductor single crystal layer include an InP layer, an InₓGa₁₋ₓAs_{y}P_{1-y} layer (0 ≤ x < 1, 0 < y ≤ 1), a GaAs layer, an AlₓGa_{y}In_{1-x-y}P layer (0 < x, 0 < y, x + y < 1), and an AlₓGa_{y}In_{1-x-y}As layer (0 < x, 0 < y < 1, x + y ≤ 1).

The method for epitaxially growing the epitaxial layer on the main surface of the group III-V compound semiconductor single crystal substrate should not be particularly limited, and from the viewpoint of growing a high-quality epitaxial layer, examples thereof include a liquid phase epitaxial growth (LPE) method and a vapor phase epitaxial growth (VPE) method. Examples of the VPE method include a hydride VPE method, a metal organic vapor phase epitaxial (MOVPE) method, and a molecular beam epitaxial growth (MBE) method.

The "defect" of the epitaxial layer refers to an LPD (light point defect) observed on the main surface of the epitaxial layer, and the number thereof can be evaluated based on the number of light scattering bright spots observed under a light collecting lamp in a dark chamber, targeting the epitaxial layer grown on the main surface of the group III-V compound semiconductor single crystal substrate. In addition, the "circle-equivalent diameter" of an LPD on the main surface of the epitaxial layer means the diameter of a circle that is equal in area to the LPD measured.

### <Main Surface>

The present inventors have examined various properties of the main surface required for reducing defects of the epitaxial layer disposed on the main surface of the group III-V compound semiconductor single crystal substrate. As a result, the present inventors have first found that there is a positive correlation between the number of first particles per unit area (hereinafter also referred to as the "density") on the main surface and the number of LPDs having a circle-equivalent diameter of 0.136 µm or more per unit area on the main surface of the epitaxial layer (thickness of 0.3 µm) disposed on the main surface. The present inventors have found that especially when the density of the first particles on the main surface (first region) is 0 /cm² or more and 13.0 /cm² or less, the number of LPDs having a circle-equivalent diameter of 0.136 µm or more on the main surface of the epitaxial layer (thickness of 0.3 µm) disposed on the main surface can be reduced to 0 /cm² or more and 21.0 /cm² or less. It has conventionally been empirically understood that the fewer there are defects in the epitaxial layer, the better a property of a semiconductor device.

Furthermore, the present inventors have found that the first particles are concentrated on the outer periphery of the main surface of the conventional group III-V compound semiconductor single crystal substrate. The reason why the first particles are unevenly distributed on the outer periphery of the main surface is presumed to be as follows. That is, it is presumed that the reason is that when a cleaning method referred to as a vertical-batch method, a face down-single wafer method, or the like is used as a liquid phase treatment that cleans the main surface of a group III-V compound semiconductor single crystal substrate precursor with a liquid phase that uses both or one of an acidic solution and an alkaline solution, a fine particle (especially an organic component) as dirt remains along a direction in which the precursor is pulled up from a cleaning tank or a direction in which the precursor is treated with a chemical solution (that is, a direction going from the center toward the outer periphery of the main surface).

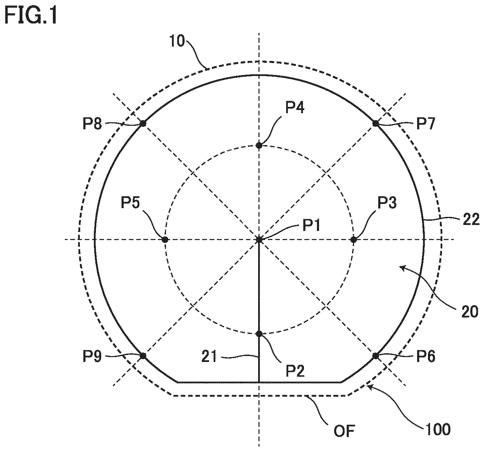

Based on the above presumption, the present inventors have found that the fine particle can be removed from the main surface by carrying out a vapor phase treatment involving carrying out ultraviolet irradiation in an ozone atmosphere or an oxygen atmosphere as described later, in addition to the liquid phase treatment, to sublimate the fine particle as carbon dioxide. This reduces the density of the first particles on the main surface (first region) of the group III-V compound semiconductor single crystal substrate according to the present embodiment to 0 /cm² or more and 13.0 /cm² or less. Furthermore, as shown in Fig. 1, the present inventors have achieved the following: in a group III-V compound semiconductor single crystal substrate 100 having a first region 20 that is a circular region inside a first virtual line 22 passing through a point 5 mm away inward from the outer periphery of a main surface 10, and a first reference line 21 that is a virtual line segment extending from the center of main surface 10 to first virtual line 22 in a direction going from the center of main surface 10 toward an orientation flat OF, when the number of the first particles is measured at each of measurement points at nine points, where the measurement points at the nine points are P1 to P9 consisting of a measurement point P1 at one point at the center of main surface 10, measurement points P2, P3, P4, and P5 at four midpoints of four virtual line segments having angles of 0 degrees, 90 degrees, 180 degrees, and 270 degrees, respectively, with respect to first reference line 21 and extending from the center to first virtual line 22, and measurement points P6, P7, P8, and P9 at four endpoints of four virtual line segments having angles of 45 degrees, 135 degrees, 225 degrees, and 315 degrees, respectively, with respect to first reference line 21 and extending from the center to first virtual line 22, the standard deviation and the average value of the number of the first particles calculated based on the measurement results thereof satisfy the relationship of standard deviation/average value ≤ 0.9.

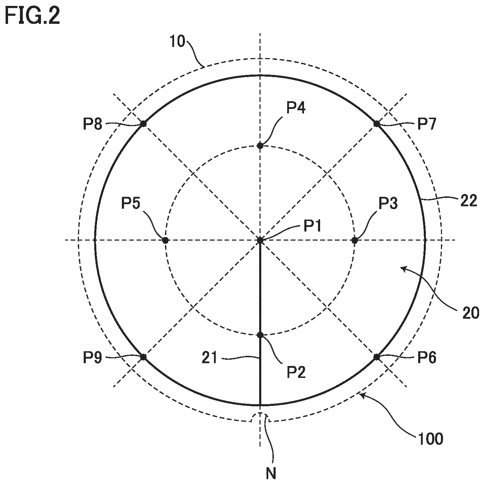

Fig. 1 is an illustrative diagram for describing the positions of measurement points at nine points on the main surface (first region) of a group III-V compound semiconductor single crystal substrate having an orientation flat, used for measuring the number of particles. In addition, Fig. 2 is an illustrative diagram for describing the positions of measurement points at nine points on the main surface (first region) of a group III-V compound semiconductor single crystal substrate having a notch, used for measuring the number of particles. In group III-V compound semiconductor single crystal substrate 100 shown in Fig. 2, a virtual line segment extending from the center of main surface 10 to first virtual line 22 in a direction going from the center of main surface 10 toward a notch N is taken as first reference line 21, and measurement points P1 to P9 at nine points in total are set. Even in group III-V compound semiconductor single crystal substrate 100 shown in Fig. 2, the standard deviation and the average value of the number satisfy the relationship of standard deviation/average value ≤ 0.9.

Here, the "direction going from the center of the main surface to the orientation flat" in the first reference line means the direction of a straight line (perpendicular line) that passes through the center of main surface 10 and is perpendicular to orientation flat OF, as shown in Fig. 1. In addition, the "direction going from the center of the main surface toward the notch" in the first reference line means the direction of a line segment connecting the center of main surface 10 and notch N at the shortest distance as shown in Fig. 2.

Each of measurement points P1 to P9 has a circular area having a diameter (ϕ) of 15 mm. The reason for setting measurement points P1 to P9 in first region 20 of group III-V compound semiconductor single crystal substrate 100 is as follows. That is, the reason is that it is determined that the region outside first region 20 on main surface 10 (the annular region sandwiched between the outer periphery of main surface 10 and first virtual line 22 passing through a point 5 mm away inward from the outer periphery) is a region that is usually not used as a material for a semiconductor device, and is not a region suitable for calculating the standard deviation/average value of the number of particles because the number of particles varies greatly from substrate to substrate. Furthermore, in consideration of the above reason, measurement points P1 to P9 in first region 20 are also selected as the measurement targets for determining the density of the first particles (0 /cm² or more and 13.0 /cm² or less). That is, herein, the density of the first particles on main surface 10 (first region 20) can be determined by converting the average value of the number of the first particles obtained from measurement points P1 to P9 into the number of the first particles per cm².

As described above, in the group III-V compound semiconductor single crystal substrate according to the present embodiment, the density of the first particles on the main surface is set to 0 /cm² or more and 13.0 /cm² or less, and the density can be reduced as compared with the conventional one. Furthermore, the standard deviation and the average value of the number of the first particles measured at each of the measurement points at the nine points in total satisfy the relationship of standard deviation/average value ≤ 0.9, thereby making it possible to uniformly reduce the number of the first particles regardless of the central portion and the outer periphery of the substrate. Thereby, the group III-V compound semiconductor single crystal substrate according to the present embodiment is more advantageous than the conventional one in that an epitaxial layer having fewer defects can be grown. Therefore, the group III-V compound semiconductor single crystal substrate according to the present embodiment can grow a high-quality epitaxial layer on the main surface, thereby making it possible to provide a high-performance semiconductor device.

From the viewpoint of growing a higher-quality epitaxial layer on the main surface of the group III-V compound semiconductor single crystal substrate, the density of the first particles on the main surface is preferably 0 /cm² or more and 8.0 /cm² or less, and more preferably 0 /cm² or more and 5.6 /cm² or less. The lower limit value of the density of the first particles is 0 /cm². The lower limit value of the density of the first particles is preferably also 0.5 particles. Furthermore, in the group III-V compound semiconductor single crystal substrate, the standard deviation and the average value of the number of the first particles measured at the measurement points at the nine points in total described above preferably satisfy the relationship of standard deviation/average value ≤ 0.75, and more preferably satisfy the relationship of standard deviation/average value ≤ 0.5. In addition, the standard deviation and the average value of the number preferably satisfy the relationship of standard deviation/average value ≥ 0.2.

Here, the group III-V compound semiconductor single crystal substrate is preferably an indium phosphide single crystal substrate or a gallium arsenide single crystal substrate as described later. When the group III-V compound semiconductor single crystal substrate is an indium phosphide single crystal substrate, the standard deviation and the average value of the number of the first particles in the indium phosphide single crystal substrate preferably satisfy the relationship of 0.23 ≤ standard deviation/average value ≤ 0.71. Furthermore, the density of the first particles is preferably 2.2 /cm² or more and 12.3 /cm² or less. This can provide, with a good yield, an indium phosphide single crystal substrate in which the density of particles on the main surface is reduced and the number of particles is uniformly small on the main surface.

When the group III-V compound semiconductor single crystal substrate is a gallium arsenide single crystal substrate, the standard deviation and the average value of the number of the first particles in the gallium arsenide single crystal substrate preferably satisfy the relationship of 0.5 ≤ standard deviation/average value ≤ 0.89. Furthermore, the density of the first particles is preferably 0.5 /cm² or more and 2.7 /cm² or less. This can provide, with a good yield, a gallium arsenide single crystal substrate in which the density of particles on the main surface is reduced and the number of particles is uniformly small on the main surface.

The number of the first particles on the main surface of the group III-V compound semiconductor single crystal substrate and the number of LPDs having a circle-equivalent diameter of 0.136 µm or more on the main surface of the epitaxial layer can each be measured by using a semiconductor laser having a wavelength of 405 nm as the light source of the light collecting lamp. As a measuring apparatus, for example, a wafer surface inspection apparatus (trade name (product number): "WM-10" manufactured by Takano Co., Ltd.) can be used. The density of the first particles (the number of the first particles per cm² of the main surface) and the number of LPDs having a circle-equivalent diameter of 0.136 µm or more per cm² of the main surface of the epitaxial layer can also be determined by the above measuring apparatus.

### [Group III-V Compound Semiconductor Single Crystal Substrate (Second Embodiment)]

The Group III-V compound semiconductor single crystal substrate according to the present embodiment can include the following characteristics in addition to or instead of the characteristics described above. That is, the group III-V compound semiconductor single crystal substrate according to the present embodiment is a group III-V compound semiconductor single crystal substrate having a circular main surface. Especially, the group III-V compound semiconductor single crystal substrate is an indium phosphide single crystal substrate. The main surface has an orientation flat or a notch. The main surface has a first region that is a circular region inside a first virtual line passing through a point 5 mm away inward from the outer periphery thereof, and a first reference line that is a virtual line segment extending from the center of the main surface to the first virtual line in a direction going from the center of the main surface toward the orientation flat or the notch.

On the main surface, the number of particles having a particle size of 0.19 µm or more at each of measurement points at nine points in total is measured, where the nine points are one point at the center, four midpoints of four virtual line segments having angles of 0 degrees, 90 degrees, 180 degrees, and 270 degrees, respectively, with respect to the first reference line and extending from the center to the first virtual line, and four endpoints of four virtual line segments having angles of 45 degrees, 135 degrees, 225 degrees, and 315 degrees, respectively, with respect to the first reference line and extending from the center to the first virtual line, and the standard deviation and the average value of the number of the particles calculated based on measurement results thereof satisfy the relationship of standard deviation/average value ≤ 1.25. Furthermore, in the first region, the density of the particles having a particle size of 0.19 µm or more is 0 /cm² or more and 0.62 /cm² or less.

In a group III-V compound semiconductor single crystal substrate having such characteristics, the density of particles having a particle size of 0.19 m or more on the main surface (first region) is as low as 0 /cm² or more and 0.62 /cm² or less, and the density of particles on the main surface can be reduced as compared with the conventional one. Furthermore, in the group III-V compound semiconductor single crystal substrate, the number of particles having a particle size of 0.19 µm or more is measured at each of the measurement points at the nine points in total described above, and the standard deviation and the average value of the number of the particles calculated based on the measurement results thereof satisfy the relationship of standard deviation/average value ≤ 1.25. This can uniformly reduce the number of particles on the main surface. Therefore, the group III-V compound semiconductor single crystal substrate according to the present embodiment can grow a high-quality epitaxial layer on the main surface, thereby making it possible to provide a high-performance semiconductor device.

The number of particles having a particle size of 0.19 m or more (hereinafter also referred to as "second particles") can be evaluated by detecting the number of light scattering bright spots observed on the main surface under a light collecting lamp in a dark chamber, as with the number of first particles. Furthermore, the "particle size" of the second particle also means the diameter of a circle that is equal in area to the particle measured as the light scattering bright spot, as with the number of the first particles.

### <Main Surface>

The present inventors have examined various properties of the main surface as described above and as a result, found that there is also a positive correlation between the density of the second particles on the main surface of the group III-V compound semiconductor single crystal substrate and the number of LPDs having a circle-equivalent diameter of 0.136 µm or more per unit area on the main surface of the epitaxial layer (thickness of 0.3 µm) disposed on the main surface of the substrate. The present inventors have found that especially when the density of the second particles on the main surface of the group III-V compound semiconductor single crystal substrate is 0 /cm² or more and 0.62 /cm² or less, the number of LPDs having a circle-equivalent diameter of 0.136 µm or more on the main surface of the epitaxial layer (thickness of 0.3 µm) disposed on the main surface of the substrate can be reduced to 0 /cm² or more and 21.0 /cm² or less.

Furthermore, in addition to the liquid phase treatment, the present inventors have carried out a vapor phase treatment involving carrying out ultraviolet irradiation in an ozone atmosphere or an oxygen atmosphere as described later, thereby reducing the density of the second particles on the main surface (first region) of the group III-V compound semiconductor single crystal substrate to 0 /cm² or more and 0.62 /cm² or less. At the same time, the present inventors have achieved the following: as shown in Fig. 1, in group III-V compound semiconductor single crystal substrate 100 having first region 20 that is a circular region inside first virtual line 22 passing through a point 5 mm away inward from the outer periphery of main surface 10, and first reference line 21 that is a virtual line segment extending from the center of main surface 10 to first virtual line 22 in a direction going from the center of main surface 10 toward orientation flat OF, when the number of the second particles is measured at each of measurement points at nine points in total, where the measurement points at the nine points are P1 to P9 consisting of a measurement point P1 at one point at the center of main surface 10, measurement points P2, P3, P4, and P5 at four midpoints of four virtual line segments having angles of 0 degrees, 90 degrees, 180 degrees, and 270 degrees, respectively, with respect to first reference line 21 and extending from the center to first virtual line 22, and measurement points P6, P7, P8, and P9 at four endpoints of four virtual line segments having angles of 45 degrees, 135 degrees, 225 degrees, and 315 degrees, respectively, with respect to first reference line 21 and extending from the center to first virtual line 22, the standard deviation and the average value of the number of the second particles calculated based on measurement results thereof satisfy the relationship of standard deviation/average value ≤ 1.25.

Each of measurement points P1 to P9 has a circular area having a diameter (ϕ) of 15 mm. The reason for setting measurement points P1 to P9 in first region 20 of group III-V compound semiconductor single crystal substrate 100 is as described above. The density of the second particles (0 /cm² or more and 0.62 /cm² or less) can be determined by converting the average value of the number of the second particles obtained from measurement points P1 to P9 into the number of the second particles per cm². In addition, as shown in Fig. 2, in group III-V compound semiconductor single crystal substrate 100 having a notch, a virtual line segment extending from the center of main surface 10 to first virtual line 22 in a direction going from the center of main surface 10 toward notch N is taken as first reference line 21, and measurement points P1 to P9 at nine points in total can be set. Even in group III-V compound semiconductor single crystal substrate 100 shown in Fig. 2, the standard deviation and the average value of the number satisfy the relationship of standard deviation/average value ≤ 1.25.

As described above, in the group III-V compound semiconductor single crystal substrate according to the present embodiment, the density of the second particles on the main surface is set to 0 /cm² or more and 0.62 /cm² or less, and the density can be reduced as compared with the conventional one. Furthermore, the standard deviation and the average value of the number of the second particles measured at each of the measurement points at the nine points in total described above satisfy the relationship of standard deviation/average value ≤ 1.25, thereby making it possible to uniformly reduce the number of the second particles regardless of the central portion and the outer periphery of the substrate. Thereby, the group III-V compound semiconductor single crystal substrate according to the present embodiment is more advantageous than the conventional one in that an epitaxial layer having fewer defects can be grown. Therefore, the group III-V compound semiconductor single crystal substrate according to the present embodiment can grow a high-quality epitaxial layer on the main surface, thereby making it possible to provide a high-performance semiconductor device.

From the viewpoint of growing a higher-quality epitaxial layer on the main surface of the group III-V compound semiconductor single crystal substrate, the density of the second particles on the main surface is preferably 0 /cm² or more and 0.40 /cm² or less, and more preferably 0 /cm² or more and 0.35 /cm² or less. The lower limit value of the density of the second particles is 0 /cm². Furthermore, in the group III-V compound semiconductor single crystal substrate, the standard deviation and the average value of the number of the second particles measured at the measurement points at the nine points in total described above preferably satisfy the relationship of standard deviation/average value ≤ 1.0, and more preferably satisfy the relationship of standard deviation/average value ≤ 0.85. In addition, the standard deviation and the average value of the number preferably satisfy the relationship of standard deviation/average value ≥ 0.0 (that is, the number of the second particles measured at the measurement points at the nine points in total described above is 0).

The number of the second particles on the main surface of the group III-V compound semiconductor single crystal substrate can be measured by using an argon ion laser having a wavelength of 488 nm as the light source of the light collecting lamp. As a measuring apparatus, for example, a wafer surface inspection apparatus (trade name (product number): "Surfscan (SFS) 6220" manufactured by KLA Tencor Corporation) can be used. The density of the second particles (the number of the second particles per cm² of the main surface) can also be determined by the measuring apparatus. The number of LPDs having a circle-equivalent diameter of 0.136 µm or more on the main surface of the epitaxial layer can be measured by using a wafer surface inspection apparatus (trade name (product number): "WM-10" manufactured by Takano Co., Ltd.) as described above.

### [Other Characteristics]

The main surface of the group III-V compound semiconductor single crystal substrate according to the present embodiment is preferably the {100} plane. Furthermore, the main surface of the group III-V compound semiconductor single crystal substrate is preferably also a plane having an off angle of more than 0° and 15° or less from the {100} plane.

In the group III-V compound semiconductor single crystal substrate, when the main surface is the {100} plane, or when the main surface has an off angle of more than 0° and 15° or less from the {100} plane, the main surface of the group III-V compound semiconductor single crystal substrate is a plane having an orientation that is excellent in an electrical property and an optical property. Thereby, the present embodiment can reduce the density of particles on the main surface of a group III-V compound semiconductor single crystal substrate having a plane that is excellent in an electrical property and an optical property as the main surface, and can uniformly reduce the number of particles on the main surface. More preferably, in the group III-V compound semiconductor single crystal substrate, the main surface is the {100} plane, or the main surface is a plane having an off angle of more than 0° and 10° or less from the {100} plane. Most preferably, in the group III-V compound semiconductor single crystal substrate, the main surface is the {100} plane, or the main surface is a plane having an off angle of more than 0° and 5° or less from the {100} plane.

The group III-V compound semiconductor single crystal substrate whose main surface is the { 100} plane is preferably obtained by cutting out the {100} just plane having no off angle as the main surface from a group III-V compound semiconductor single crystal that is the raw material of the group III-V compound semiconductor single crystal substrate. When obtaining such a group III-V compound semiconductor single crystal, the orientation of the interface between a seed crystal and a raw material melt in contact with the seed crystal is preferably the { 100} just plane. Furthermore, the growth direction of the III-V compound semiconductor single crystal is preferably the <100> direction.

Furthermore, a group III-V compound semiconductor single crystal substrate whose main surface is a plane having an off angle of more than 0° and 15° or less from the {100 } plane can be obtained from a group III-V compound semiconductor single crystal that is the raw material of the group III-V compound semiconductor single crystal substrate, by carrying out inclined slicing by using a conventionally known method. In this case, the properties regarding the number of particles on the main surface of the group III-V compound semiconductor single crystal substrate whose main surface is a plane having an off angle of more than 0° and 15° or less from the {100} plane are substantially the same as those of the group III-V compound semiconductor single crystal substrate whose main surface is the { 100} just plane.

The off angle from the { 100} plane on the main surface of the group III-V compound semiconductor single crystal substrate can be measured by using a conventionally known crystal orientation measuring apparatus (for example, trade name (product number): "2991G2" manufactured by Rigaku Corporation).

The main surface of the group III-V compound semiconductor single crystal substrate may be coated with a protective film. Thereby, the attachment of an impurity or the like that serves as a particle on the main surface is suppressed, and thus the main surface can be kept clean. The protective film should not be particularly limited, and preferably includes a surfactant from the viewpoint of keeping the cleanness of the main surface. Especially, the surfactant is preferably a nonionic surfactant. Examples of the nonionic surfactant include a higher alcohol type nonionic surfactant or an alkylphenol type nonionic surfactant, which has a molecular weight of 700 to 2000, such as polyoxyalkylene alkyl ether, polyoxyethylene alkyl ether, or polyoxyethylene alkylphenyl ether, and a fatty acid type nonionic surfactant such as a sucrose fatty acid salt/ester, a sorbitan fatty acid ester, a polyoxyethylene sorbitan fatty acid ester, a polyoxyethylene fatty acid ester, or an alkanol amide.

From the viewpoint of keeping the cleanness of the main surface, the thickness of the protective film is preferably 0.3 nm or more, and more preferably 0.5 nm or more. In addition, from the viewpoint of suppressing clouding of the main surface, the thickness is preferably 3 nm or less, and more preferably 2 nm or less. The thickness of the protective film can be measured by a spectroscopic ellipsometer (trade name (product number): "SE-101" manufactured by Photonic Lattice, Inc.).

### <Indium Phosphide Single Crystal Substrate: InP Substrate>

The group III-V compound semiconductor single crystal substrate according to the present embodiment is preferably an indium phosphide single crystal substrate (hereinafter also referred to as an "InP substrate"). This can provide an InP substrate in which the density of particles on the main surface is reduced and the number of particles is uniformly small on the main surface. Especially, in the InP substrate, the diameter of the main surface is preferably 75 mm or more and 155 mm or less. Thereby, the group III-V compound semiconductor single crystal substrate according to the present embodiment can reduce the density of particles on the main surface of a large InP substrate having a diameter of 75 mm or more and 155 mm or less, and uniformly reduce the number of particles on the main surface.

Specifically, an InP substrate in which the diameter of the main surface is 75 mm or more and 155 mm or less preferably refers to an InP substrate in which the diameter of the main surface is 75 mm, 100 mm, or 150 mm, in other words, an InP substrate in which the diameter of the main surface is 3 inches, 4 inches, or 6 inches. As described above, the diameter of the main surface can be measured by using a conventionally known outer diameter measuring instrument such as vernier calipers.

For the InP substrate, the substrate may be doped with an impurity atom in order to impart a property such as conductivity or a semi-insulating property. For example, the substrate can be doped with an Fe (iron) atom in order to lower the conductivity, and can be doped with both or one of a S (sulfur) atom and a Sn (tin) atom in order to increase the conductivity. A semi-insulating InP substrate doped with an Fe (iron) atom can, for example, have a specific resistance of 1 × 10⁷ **Ω**·cm or more and 5 × 10⁸ **Ω**·cm or less. A conductive InP substrate doped with both or one of a S (sulfur) atom and a Sn (tin) atom can, for example, have a specific resistance of 1 **Ω**·cm or less.

### <Gallium Arsenide Single Crystal Substrate: GaAs Substrate>

The group III-V compound semiconductor single crystal substrate according to the present embodiment is preferably a gallium arsenide single crystal substrate (hereinafter also referred to as a "GaAs substrate"). This can provide a GaAs substrate in which the density of particles on the main surface is reduced and the number of particles is uniformly small on the main surface. Especially, in the GaAs substrate, the diameter of the main surface is preferably 75 mm or more and 205 mm or less. Thereby, the group III-V compound semiconductor single crystal substrate according to the present embodiment can reduce the density of particles on the main surface of a large GaAs substrate having a diameter of 75 mm or more and 205 mm or less, and uniformly reduce the number of particles on the main surface.

Specifically, a GaAs substrate in which the diameter of the main surface is 75 mm or more and 205 mm or less preferably refers to a GaAs substrate in which the diameter of the main surface is 75 mm, 100 mm, 150 mm, or 200 mm, in other words, a GaAs substrate in which the diameter of the main surface is 3 inches, 4 inches, 6 inches, or 8 inches. As described above, the diameter of the main surface can be measured by using a conventionally known outer diameter measuring instrument such as vernier calipers.

For the GaAs substrate, the substrate may be doped with an impurity atom in order to impart a property such as conductivity. Examples of a donor dopant added in order to impart n-type conductivity include a Si (silicon) atom and a Te (tellurium) atom, and examples of an acceptor dopant added in order to impart p-type conductivity include a Zn (zinc) atom.

### [Method for Manufacturing Group III-V Compound Semiconductor Single Crystal Substrate]

The method for manufacturing a group III-V compound semiconductor single crystal substrate according to the present embodiment is preferably a manufacturing method for manufacturing the group III-V compound semiconductor single crystal substrate described above. The manufacturing method includes a cleaning step for obtaining a group III-V compound semiconductor single crystal substrate having a circular main surface from a group III-V compound semiconductor single crystal substrate precursor. The cleaning step includes following steps in order of: a liquid phase treating step of cleaning the group III-V compound semiconductor single crystal substrate precursor with a liquid phase, a vapor phase treating step of cleaning the group III-V compound semiconductor single crystal substrate precursor with a vapor phase, and an oxide film removing step of removing an oxide film attached to the group III-V compound semiconductor single crystal substrate precursor. Especially, the vapor phase treating step includes irradiating the group III-V compound semiconductor single crystal substrate precursor with ultraviolet radiation in an ozone atmosphere or in an oxygen-containing atmosphere. The oxide film removing step includes removing the oxide film with a first solution including hydrofluoric acid at 0.1% by mass or more. A method for manufacturing a group III-V compound semiconductor single crystal substrate having such characteristics can manufacture a group III-V compound semiconductor single crystal substrate in which the density of particles on the main surface is reduced and the number of particles is uniformly small on the main surface.

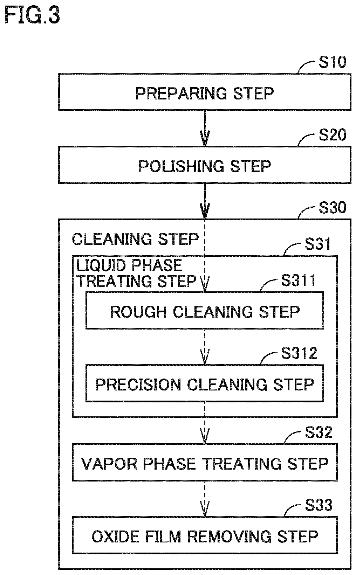

The group III-V compound semiconductor single crystal substrate obtained by the above manufacturing method is preferably an indium phosphide single crystal substrate (InP substrate). This is capable of manufacturing an InP substrate in which the density of particles on the main surface is reduced and the number of particles is uniformly small on the main surface. The group III-V compound semiconductor single crystal substrate obtained by the above manufacturing method is preferably also a gallium arsenide single crystal substrate (GaAs substrate). This is capable of manufacturing a GaAs substrate in which the density of particles on the main surface is reduced and the number of particles is uniformly small on the main surface. Hereinafter, with reference to Fig. 3, an example of the method for manufacturing an InP substrate according to the present embodiment for obtaining an InP substrate as a group III-V compound semiconductor single crystal substrate will be described.

From the viewpoint of manufacturing an InP substrate with a good yield, the method for manufacturing an InP substrate is preferably the following manufacturing method including a cleaning step for obtaining an InP substrate having a circular main surface. That is, as shown in Fig. 3, the method for manufacturing an InP substrate can include a preparing step S10 of preparing a circular group III-V compound semiconductor single crystal substrate precursor (InP substrate precursor) by cutting out an InP single crystal in a predetermined plane orientation, a polishing step S20 of polishing the InP substrate precursor, and a cleaning step S30 of cleaning the polished InP substrate precursor. Cleaning step S30 includes following steps in order of: a liquid phase treating step S3 1 of cleaning the InP substrate precursor with a liquid phase, a vapor phase treating step S32 of cleaning the InP substrate precursor with a vapor phase, and an oxide film removing step S33 of removing an oxide film attached to the InP substrate precursor. Hereinafter, each step will be described in order.

### <Preparing Step>

Preparing step S 10 is preparing a circular InP substrate precursor by cutting out an InP single crystal in a predetermined plane orientation. In preparing step S 10, an InP substrate precursor can be formed by subjecting an InP single crystal to conventionally known slicing and chamfering. The method for manufacturing an InP single crystal should not be particularly limited, and a VB (vertical Bridgman) method, a VGF (vertical temperature gradient freezing) method, an LEC (liquid encapsulated Czochralski) method, or the like can be suitably used. When an InP single crystal is sliced and chamfered to cut out an InP substrate precursor in a predetermined plane orientation from the InP single crystal, it is preferable to cut out the InP substrate precursor such that the main surface is the {100} just plane having no off-angle as described above, or to cut out an InP substrate precursor such that the main surface is a plane having an off angle of more than 0° and 15° or less from the {100} plane, by carrying out conventionally known inclined slicing.

### <Polishing Step>

Polishing step S20 is polishing the main surface of the InP substrate precursor. The polishing method used in polishing step S20 should not be particularly limited, and mechanical polishing, chemical mechanical polishing (CMP), chemical polishing, or the like can be suitably used.

### <Cleaning Step>

As described above, cleaning step S30 includes following steps in order of: liquid phase treating step S31 of cleaning the InP substrate precursor with a liquid phase, vapor phase treating step S32 of cleaning the InP substrate precursor with a vapor phase, and oxide film removing step S33 of removing an oxide film attached to the InP substrate precursor. Liquid phase treating step S31 can use a conventionally known liquid phase cleaning method, and can include, for example, a rough cleaning step S311 of roughly cleaning the InP substrate precursor and a precision cleaning step S312 of precisely cleaning the roughly cleaned InP substrate precursor.

### (Liquid Phase Treating Step: Rough Cleaning Step)

Rough cleaning step S311 is roughly cleaning the InP substrate precursor with the main surface polished. In rough cleaning step S311, cleaning with an alkaline solution, or both cleaning with a hydrofluoric acid solution and cleaning with an alkaline solution can be carried out for the purpose of removing an abrasive, a polishing liquid, and the like attached to the main surface.

### (Liquid Phase Treating Step: Precision Cleaning Step)

Precision cleaning step S312 is precisely cleaning the roughly cleaned InP substrate precursor. Specifically, precision cleaning step S312 can be carrying out a sulfuric acid/hydrogen peroxide mixture cleaning step of cleaning the roughly cleaned InP substrate precursor with a sulfuric acid/hydrogen peroxide mixture, a phosphoric acid cleaning step of cleaning with phosphoric acid, and a drying step. In the sulfuric acid/hydrogen peroxide mixture cleaning step, the roughly cleaned InP substrate precursor can be cleaned with a sulfuric acid/ hydrogen peroxide mixture (aqueous solution including sulfuric acid and hydrogen peroxide). This makes it possible to reduce the organic film and the oxide film formed on the main surface of the InP substrate precursor, as well as Si (silicon) and the like attached to the main surface. In the phosphoric acid cleaning step, the InP substrate precursor cleaned with a sulfuric acid/hydrogen peroxide mixture can be cleaned with phosphoric acid. This makes it possible to reduce SO₄²⁻ derived from sulfuric acid attached to the main surface of the InP substrate precursor, as well as Si and the like remaining on the main surface. It is preferable to include cleaning by ultra-pure water rinsing after each cleaning in the sulfuric acid/hydrogen peroxide mixture cleaning step and the phosphoric acid cleaning step. "Ultra-pure water" used for the ultra-pure rinsing refers to water that has an electric resistivity (specific resistance) of 18 M**Ω**·cm or more, a TOC (total organic carbon) of less than 10 µg/L (liter), and the number of fine particles of less than 100 particles/L (liter). In the drying step, the InP substrate precursor cleaned with phosphoric acid can be dried. The drying method should not be particularly limited, and from the viewpoint of suppressing attachment of a particle to the main surface, a spin drying method, an IPA (isopropyl alcohol) vapor drying method, a hot air drying method, or the like is preferred. The cleaning method in the precision cleaning step should not be particularly limited, and a conventionally known method such as a vertical-batch method or a face down single wafer method can be used.

### (Vapor Phase Treating Step)

Vapor phase treating step S32 is cleaning the InP substrate precursor with a vapor phase. Specifically, vapor phase treating step S32 includes irradiating the InP substrate precursor with ultraviolet radiation in an ozone atmosphere or in an oxygen-containing atmosphere. By vapor phase treating step S32, a particle (especially an organic component) attached to the main surface of the InP substrate precursor can be oxidized to carbon dioxide, thereby sublimated, and removed from the main surface.

The irradiating with ultraviolet radiation is preferably carried out under conditions of 25°C or more and 150°C or less and 1 minute or more and 60 minutes or less. The irradiating with ultraviolet radiation can be carried out by using, for example, a vapor phase cleaning apparatus (trade name (product number): "UV Ozone Cleaner UV-1" manufactured by Samco Inc.). From the viewpoint of more efficiently removing a particle (especially an organic component) from the main surface of the InP substrate precursor, the irradiating with ultraviolet radiation is more preferably carried out under a condition that satisfy at least one of a temperature condition of 70°C or more and 100°C or less and a time condition of 3 minutes or more and 20 minutes or less. That is, the irradiating with ultraviolet radiation is preferably carried out under conditions of 25°C or more and 150°C or less and 1 minute or more and 60 minutes or less, more preferably carried out under conditions of 70°C or more and 100°C or less and 1 minute or more and 60 minutes or less, or under conditions of 25°C or more and 150°C or less and 3 minutes or more and 20 minutes or less, and most preferably carried out under conditions of 70°C or more and 100°C or less and 3 minute or more and 20 minutes or less.

### (Oxide Film Removing Step)

Oxide film removing step S33 is removing an oxide film attached to the InP substrate precursor. Specifically, oxide film removing step S33 includes removing the oxide film with a first solution including hydrofluoric acid at 0.1% by mass or more. An oxide film is formed, instead of a particle being removed by oxidation, on the main surface of the InP substrate precursor that has undergone vapor phase treating step S32, and thus the purpose of oxide film removing step S33 is to use the first solution to remove the oxide film. From the viewpoint of removing the oxide film more efficiently in oxide film removing step S33, the first solution preferably further includes ammonium fluoride. The concentration of hydrofluoric acid in the first solution is preferably 0.15% by mass or more. Furthermore, the concentration of ammonium fluoride in the first solution is preferably 1 time or more and 10 times or less the concentration of hydrofluoric acid.

Oxide film removing step S33 can be carried out by immersing the InP substrate precursor that has undergone vapor phase treating step S32 in the first solution for a predetermined time (for example, 1 to 5 minutes). After that, the InP substrate precursor from which the oxide film has been removed is preferably subjected to running water cleaning with running ultra-pure water, for example, at a flow rate of 1 to 10 L/min. Next, the InP substrate precursor subjected to running water cleaning is preferably dried by a spin drying method, an IPA (isopropyl alcohol) vapor drying method, a hot air drying method, or the like. By cleaning step S30 described above, an InP substrate having a circular main surface can be obtained from the InP substrate precursor.

### (Further Step: Protective Film Forming Step)

The method for manufacturing a group III-V compound semiconductor single crystal substrate according to the present embodiment can further include a protective film forming step of coating the main surface of the group III-V compound semiconductor single crystal substrate that has undergone the oxide film removing step with a protective film. This makes it possible to keep the main surface of the group III-V compound semiconductor single crystal substrate clean. For example, the main surface of the group III-V compound semiconductor single crystal substrate is coated with a protective film, thereby making it possible to reduce defects of the epitaxial layer disposed on the main surface of the group III-V compound semiconductor single crystal substrate even after storage for 1 year. Here, when the protective film is composed of a component as described above, the protective film evaporates in the temperature rising process before epitaxial growth, and does not remain on the main surface immediately before epitaxial growth.

### (Further Steps: Rough Cleaning Step and Precision Cleaning Step)

Furthermore, when the method for manufacturing a group III-V compound semiconductor single crystal substrate according to the present embodiment is applied to, for example, a gallium arsenide single crystal substrate (GaAs substrate), the following rough cleaning step and precision cleaning step can be applied instead of the rough cleaning step and the precision cleaning step described above in the liquid phase treating step in the cleaning step.

That is, for example, in the rough cleaning step, a GaAs substrate with the main surface polished can be cleaned with a wafer cleaning liquid and cleaned by ultra-pure water rinsing in order to remove an abrasive, a polishing liquid, and the like attached to the main surface. The cleaning with a wafer cleaning liquid and the cleaning by ultra-pure water rinsing can be repeated a plurality of times. As the wafer cleaning liquid, for example, a tetramethylammonium hydroxide aqueous solution is preferably used. The ultra-pure water used for the ultra-pure water rinsing is the same as the ultra-pure water used for the ultra-pure water rinsing used in the cleaning step of the InP substrate precursor described above, and thus no redundant description will be repeated.

Furthermore, in the precision cleaning step, the roughly cleaned GaAs substrate can be cleaned with an acid, cleaned by ultra-pure water rinsing, and dried. As a cleaning liquid used for the acid cleaning, for example, a nitric acid aqueous solution is preferably used. The ultra-pure water used for the ultra-pure water rinsing is the same as the ultra-pure water used for the ultra-pure water rinsing used in the cleaning step of the InP substrate precursor described above, and thus no redundant description will be repeated. The drying method is also the same as the drying method used in the cleaning step of the InP substrate precursor described above, and thus no redundant description will be repeated.

### <Action and Effect>

As described above, the method for manufacturing a group III-V compound semiconductor single crystal substrate according to the present embodiment is capable of manufacturing the group III-V compound semiconductor single crystal substrate described above. In a group III-V compound semiconductor single crystal substrate obtained by the above manufacturing method, the density of the first particles especially on the main surface (first region) is as low as 0 /cm² or more and 13.0 /cm² or less, and the density of the first particles on the main surface can be reduced as compared with the conventional one. Furthermore, the standard deviation/average value of the number of the first particles measured at the measurement points at the nine points in total described above satisfies the relationship of standard deviation/average value ≤ 0.9, and thus the number of the first particles can be uniformly reduced on the main surface. Therefore, the group III-V compound semiconductor single crystal substrate can grow a high-quality epitaxial layer on the main surface, thereby making it possible to provide a high-performance semiconductor device.

When the group III-V compound semiconductor single crystal substrate is an indium phosphide single crystal substrate, the standard deviation and the average value of the number of the first particles in the indium phosphide single crystal substrate preferably satisfy the relationship of 0.23 ≤ standard deviation/average value ≤ 0.71. Furthermore, the density of the first particles is preferably 2.2 /cm² or more and 12.3 /cm² or less. This can provide, with a good yield, an indium phosphide single crystal substrate in which the density of particles on the main surface is reduced and the number of particles is uniformly small on the main surface.

In addition, in an indium phosphide single crystal substrate obtained by the above manufacturing method, the density of the second particles on the main surface (first region) is as low as 0 /cm² or more and 0.62 /cm² or less, and the density of the second particles on the main surface can be reduced as compared with the conventional one. Furthermore, the standard deviation/average value of the number of the second particles measured at the measurement points at the nine points in total described above satisfies the relationship of standard deviation/average value ≤ 1.25, and thus the number of the second particles can also be uniformly reduced on the main surface.

When the group III-V compound semiconductor single crystal substrate is a gallium arsenide single crystal substrate, the standard deviation and the average value of the number of the first particles in the gallium arsenide single crystal substrate preferably satisfy the relationship of 0.5 ≤ standard deviation/average value ≤ 0.89. Furthermore, the density of the first particles is preferably 0.5 /cm² or more and 2.7 /cm² or less. This can provide, with a good yield, a gallium arsenide single crystal substrate in which the density of particles on the main surface is reduced and the number of particles is uniformly small on the main surface.

### Examples

Hereinafter, the present disclosure will be described in more detail with reference to Examples, but the present disclosure is not limited thereto. In each of the Examples and the Comparative Examples described later, a group III-V compound semiconductor crystal was grown by using a conventionally known VB method with the <100> direction as the growth direction, and then cut out to obtain a group III-V compound semiconductor single crystal substrate precursor having a main surface having a plane orientation of the {100} just plane. Furthermore, in each of the Examples and the Comparative Examples, 100 group III-V compound semiconductor single crystal substrates were obtained by applying the method for manufacturing a group III-V compound semiconductor single crystal substrate including the following cleaning step to the group III-V compound semiconductor single crystal substrate precursor.

### [Comparative Example 1: S (Sulfur)-doped InP Substrate (<p75 mm)]

### <Preparation of Group III-V Compound Semiconductor Single Crystal Substrate (InP Substrate)>

### (Preparing Step)

A conductive InP single crystal doped with a S atom, manufactured by the VB method was sliced and chamfered to prepare an InP substrate precursor having a diameter of 75 mm (3 inches) having a main surface having a plane orientation of the {100} just plane. In addition, an orientation flat was formed on the outer periphery of the main surface of the InP substrate precursor in the crystal orientation [010] direction.

### (Polishing Step)

The main surface of the InP substrate precursor was polished by mechanical polishing and chemical mechanical polishing (CMP) to a mirror surface where the arithmetic average roughness Ra of the main surface defined by JIS B0601: 2001 was 0.3 nm or less.

### (Liquid Phase Treating Step: Rough Cleaning Step)

The InP substrate precursor that had undergone the polishing step was, in accordance with the vertical-batch method, cleaned by immersion in a 10% by mass choline aqueous solution as an alkaline solution at room temperature (25°C) for 5 minutes, cleaned by immersion in a 5% by mass hydrofluoric acid aqueous solution at room temperature (25°C) for 5 minutes, and further cleaned by immersion in a 5% by mass choline aqueous solution at room temperature (25°C) for 5 minutes.

### (Liquid Phase Treating Step: Precision Cleaning Step)

The InP substrate precursor that had undergone the rough cleaning step was precisely cleaned by the face down single wafer method. Specifically, the InP substrate precursor was precisely cleaned by sulfuric acid/hydrogen peroxide mixture cleaning, ultra-pure water rinsing, phosphoric acid cleaning, and ultrapure water rinsing in presented order. In the sulfuric acid/hydrogen peroxide mixture cleaning, 0.25 L (liters) of an aqueous solution including 96% by mass sulfuric acid and 30% by mass hydrogen peroxide was supplied to the main surface of the InP substrate precursor at room temperature (25°C) over 1 minute. In the subsequent ultra-pure water rinsing, 5 L (liters) of ultra-pure water was supplied to the main surface of the InP substrate precursor at room temperature (25°C) over 5 minutes. Furthermore, in the phosphoric acid cleaning, 0.2 L (liters) of a 25% by mass phosphoric acid aqueous solution was supplied to the main surface of the InP substrate precursor at room temperature (25°C) over 1 minute. In the subsequent ultra-pure water rinsing, 5 L (liters) of ultra-pure water was supplied to the main surface of the InP substrate precursor at room temperature (25°C) over 5 minutes. By carrying out the above cleaning step, an InP substrate of Comparative Example 1 was obtained from the InP substrate precursor.

### <Measurement of First Particles and Second Particles on Main Surface of InP Substrate>

In the InP substrate, a first region that was a circular region inside a first virtual line passing through a point 5 mm away inward from the outer periphery of the main surface was selected as the measurement target, and first, the standard deviation/average value of the number of first particles was determined. Specifically, by using the above wafer surface inspection apparatus (trade name (product number): "WM-10" manufactured by Takano Co., Ltd.), the number of first particles was measured at each of measurement points at nine points in total, where the measurement points at the nine points in total were P1 to P9 consisting of a measurement point P1 at one point at the center of the main surface, measurement points P2, P3, P4, and P5 at four midpoints of four virtual line segments having angles of 0 degrees, 90 degrees, 180 degrees, and 270 degrees, respectively, with respect to a first reference line that is a virtual line segment extending from the center of the main surface to the outer periphery of the first virtual line in a direction going from the center of the main surface toward an orientation flat and extending from the center to the first virtual line, and measurement points P6, P7, P8, and P9 at four endpoints of four virtual line segments having angles of 45 degrees, 135 degrees, 225 degrees, and 315 degrees, respectively, with respect to the first reference line and extending from the center to the first virtual line, and the standard deviation/the average value of the number of the first particles was determined based on measurement results thereof (see Fig. 1 for the positions of measurement points P1 to P9). The results are shown in Table 1.

Next, the first region was targeted, and the average value of the number of the first particles obtained from measurement points P1 to P9 was converted into the number of the first particles per cm² to determine the density of the first particles on the main surface. As a result, the density of the first particles was 13.6 /cm².

The number of the first particles was measured by using the wafer surface inspection apparatus (trade name (product number): "WM-10" manufactured by Takano Co., Ltd.) under the following conditions.
Measurement condition: S-QUARTE
Gain: Gain-COP
Mode: High resolution (high resolution mode)
Laser power: 30 mW for both high incidence mode and low incidence mode.

Under the above conditions, the number of the first particles at each of measurement points P1 to P9 is automatically calculated from the measurement results in high incidence mode and low incidence mode. Here, for the measurement of the first particles, the particle size and the number thereof can be calculated more accurately by carrying out the following pre-measurement. That is, an InP substrate for calibration where the particle size and the number of the particles are guaranteed is prepared in advance, the number of the particles on the InP substrate for calibration is measured by using the above apparatus, and a variable parameter of the apparatus is corrected such that the values of the number match, to complete the pre-measurement. If the variable parameter adjusted by the pre-measurement as described above is adopted, the particle size and the number can be calculated more accurately. The InP substrate for calibration can be prepared by coating an InP substrate with a certain number of particles for calibration (for example, the number of particles that do not overlap each other) that guarantees a plurality of particle sizes including 0.079 µm (0.079 µm , 0.100 µm, 0.136 µm, 0.202 µm, 0.309 µm, 1.005 µm , 2.005 µm, and 5.124 µm).

Next, in the InP substrate, the first region was targeted, and the standard deviation/average value of the number of second particles was determined. Specifically, by using the above wafer surface inspection apparatus (trade name (product number): "Surfscan (SFS) 6220" manufactured by KLA Tencor Corporation), the number of second particles was measured at each of measurement points at nine points in total under conditions of Gain 4 and Throughput medium, where the measurement points at the nine points in total were P1 to P9 consisting of a measurement point P1 at one point at the center of the main surface, measurement points P2, P3, P4, and P5 at four midpoints of four virtual line segments having angles of 0 degrees, 90 degrees, 180 degrees, and 270 degrees, respectively, with respect to a first reference line that is a virtual line segment extending from the center of the main surface to the first virtual line in a direction going from the center of the main surface toward an orientation flat and extending from the center to the first virtual line, and measurement points P6, P7, P8, and P9 at four endpoints of four virtual line segments having angles of 45 degrees, 135 degrees, 225 degrees, and 315 degrees, respectively, with respect to the first reference line and extending from the center to the first virtual line, and the standard deviation/the average value of the number of the second particles was determined based on measurement results thereof (see Fig. 1 for the positions of measurement points P1 to P9). The results are shown in Table 1.

Next, the first region was targeted, and the average value of the number of the second particles obtained from measurement points P1 to P9 was converted into the number of the second particles per cm² to determine the density of the second particles on the main surface. As a result, the density of the second particles was 0.23 /cm².

### <Formation of Epitaxial Layer and Measurement of LPD>

Next, on the main surface of the InP substrate, an InP layer having a thickness of 0.3 µm was grown as an epitaxial layer by the MOVPE method. Thereby, an epitaxial layer-attached InP substrate of Comparative Example 1 was prepared.

In the epitaxial layer of the epitaxial layer-attached InP substrate, a region corresponding to the first region of the InP substrate (that is, a circular region inside a virtual line passing through a point 5 mm away inward from the outer periphery of the main surface of the epitaxial layer (hereinafter also referred to as a "second virtual line")) was selected as the measurement target, and the number of LPDs having a circle-equivalent diameter of 0.136 µm or more was measured by using the above wafer surface inspection apparatus (trade name (product number): "WM-10" manufactured by Takano Co., Ltd.). Specifically, the number of LPDs having a circle-equivalent diameter of 0.136 µm or more was determined at measurement points corresponding to measurement points P1 to P9 on the main surface of the InP substrate (that is, measurement points at nine points in total consisting of a measurement point at one point at the center of the main surface of the epitaxial layer of the epitaxial layer-attached InP substrate, measurement points at four midpoints of four virtual line segments having angles of 0 degrees, 90 degrees, 180 degrees, and 270 degrees, respectively, with respect to a reference line that is a virtual line segment extending from the center of the main surface to the second virtual line in a direction going from the center of the main surface toward an orientation flat (hereinafter also referred to as a "second reference line") and extending from the center to the second virtual line, and measurement points at four endpoints of four virtual line segments having angles of 45 degrees, 135 degrees, 225 degrees, and 315 degrees, respectively, with respect to the second reference line and extending from the center to the second virtual line). The results are shown in Table 1. Table 1 also shows the device yield (%) of 100 devices each manufactured from a region including the measurement points at the nine points in total on the substrate. The conditions for measuring the number of LPDs having a circle-equivalent diameter of 0.136 µm or more by using the wafer surface inspection apparatus (trade name (product number): "WM-10" manufactured by Takano Co., Ltd.) are the same as the conditions for the first particles.

### [Table 1]

**Table. 1**

| Measurement point | Number of particles having particle size of 0.079 µm or more at measurement point (ϕ15 mm) on main surface of InP substrate (particles) | Number of particles having particle size of 0.19 µm or more at measurement point (ϕ15 mm) on main surface of InP substrate (particles) | Number of LPDs having circle-equivalent diameter of 0.136 µm or more at measurement point (ϕ15 mm) on main surface of epitaxial layer of epitaxial layer-attached InP substrate (defects) | Device yield (%) |
|---|---|---|---|---|
| P1 | 10 | 0 | 10 | 90 |
| P2 | 4 | 0 | 9 | 92 |
| P3 | 6 | 0 | 19 | 93 |
| P4 | 8 | 1 | 15 | 95 |
| P5 | 13 | 0 | 21 | 94 |
| P6 | 81 | 2 | 191 | 60 |
| P7 | 32 | 0 | 55 | 90 |
| P8 | 44 | 1 | 123 | 75 |
| P9 | 18 | 0 | 42 | 92 |
| Average | 24.1 | 0.4 | - | - |
| σ | 25.1 | 0.7 | - | - |
| σ/average | 1.04 | 1.75 | - | - |

### [Comparative Example 2: S (Sulfur)-doped InP Substrate (ϕ100 mm)]

### <Preparation of Group III-V Compound Semiconductor Single Crystal Substrate (InP Substrate)>

An InP substrate of Comparative Example 2 was prepared in the same manner as was the InP substrate of Comparative Example 1, except that an InP substrate precursor having a diameter of 100 mm (4 inches) having a main surface having a plane orientation of the {100} just plane was prepared in the preparing step.

### <Measurement of First Particles and Second Particles on Main Surface of InP Substrate>

In the InP substrate of Comparative Example 2, the density of the first particles, the standard deviation/average value of the number of the first particles at measurement points P1 to P9, the density of the second particles, and the standard deviation/average value of the number of the second particles at measurement points P1 to P9 were determined in the same manner as in the measurement carried out in the InP substrate of Comparative Example 1.

The density of the first particles in the InP substrate of Comparative Example 2 was 15.0 /cm², and the density of the second particles was 0.34 /cm². The standard deviation/average value of the number of the first particles at measurement points P1 to P9 and the standard deviation/average value of the number of the second particles at measurement points P1 to P9 in the InP substrate of Comparative Example 2 are shown in Table 2.

### <Formation of Epitaxial Layer and Measurement of LPD>

An epitaxial layer-attached InP substrate of Comparative Example 2 was prepared in the same manner as was the epitaxial layer-attached InP substrate of Comparative Example 1. Furthermore, in the epitaxial layer-attached InP substrate of Comparative Example 2, the number of LPDs having a circle-equivalent diameter of 0.136 µm or more at measurement points corresponding to measurement points P1 to P9 was determined in the same manner as in the measurement carried out in the epitaxial layer-attached InP substrate of Comparative Example 1. The results are shown in Table 2. Table 2 also shows the device yield (%) of 100 devices each manufactured from a region including measurement points P1 to P9 on the substrate.

### [Table 2]

**Table. 2**

| Measurement point | Number of particles having particle size of 0.079 µm or more at measurement point (ϕ15 mm) on main surface of InP substrate (particles) | Number of particles having particle size of 0.19 µm or more at measurement point (ϕ15 mm) on main surface of InP substrate (particles) | Number of LPDs having circle-equivalent diameter of 0.136 µm or more at measurement point (ϕ15 mm) on main surface of epitaxial layer of epitaxial layer-attached InP substrate (defects) | Device yield (%) |
|---|---|---|---|---|
| P1 | 8 | 1 | 5 | 95 |
| P2 | 9 | 0 | 10 | 92 |
| P3 | 3 | 0 | 13 | 93 |
| P4 | 6 | 0 | 19 | 93 |
| P5 | 13 | 0 | 26 | 91 |
| P6 | 48 | 1 | 109 | 77 |
| P7 | 21 | 0 | 20 | 92 |
| P8 | 95 | 3 | 232 | 55 |
| P9 | 36 | 0 | 87 | 70 |
| Average | 26.5 | 0.6 | - | - |
| σ | 29.8 | 1.0 | - | - |
| σ/average | 1.12 | 1.67 | - | - |

### [Comparative Example 3: S (Sulfur)-doped InP Substrate (ϕ150 mm)]

### <Preparation of Group III-V Compound Semiconductor Single Crystal Substrate (InP Substrate)>

An InP substrate of Comparative Example 3 was prepared in the same manner as was the InP substrate of Comparative Example 1, except that an InP substrate precursor having a diameter of 150 mm (6 inches) having a main surface having a plane orientation of the {100} just plane was prepared in the preparing step.

### <Measurement of First Particles and Second Particles on Main Surface of InP Substrate>

In the InP substrate of Comparative Example 3, the density of the first particles, the standard deviation/average value of the number of the first particles at measurement points P1 to P9, the density of the second particles, and the standard deviation/average value of the number of the second particles at measurement points P1 to P9 were determined in the same manner as in the measurement carried out in the InP substrate of Comparative Example 1.

The density of the first particles in the InP substrate of Comparative Example 3 was 22.1 /cm², and the density of the second particles was 0.62 /cm². The standard deviation/average value of the number of the first particles at measurement points P1 to P9 and the standard deviation/average value of the number of the second particles at measurement points P1 to P9 in the InP substrate of Comparative Example 3 are shown in Table 3.

### <Formation of Epitaxial Layer and Measurement of LPD>

An epitaxial layer-attached InP substrate of Comparative Example 3 was prepared in the same manner as was the epitaxial layer-attached InP substrate of Comparative Example 1. Furthermore, in the epitaxial layer-attached InP substrate of Comparative Example 3, the number of LPDs having a circle-equivalent diameter of 0.136 µm or more at measurement points corresponding to measurement points P1 to P9 was determined in the same manner as in the measurement carried out in the epitaxial layer-attached InP substrate of Comparative Example 1. The results are shown in Table 3. Table 3 also shows the device yield (%) of 100 devices each manufactured from a region including measurement points P1 to P9 on the substrate.

### [Table 3]

**Table. 3**

| Measurement point | Number of particles having particle size of 0.079 µm or more at measurement point (ϕ15 mm) on main surface of InP substrate (particles) | Number of particles having particle size of 0.19 µm or more at measurement point (ϕ15 mm) on main surface of InP substrate (particles) | Number of LPDs having circle-equivalent diameter of 0.136 µm or more at measurement point (ϕ15 mm) on main surface of epitaxial layer of epitaxial layer-attached InP substrate (defects) | Device yield (%) |
|---|---|---|---|---|
| P1 | 12 | 0 | 29 | 94 |
| P2 | 18 | 0 | 24 | 95 |
| P3 | 11 | 0 | 22 | 94 |
| P4 | 15 | 0 | 17 | 95 |
| P5 | 39 | 1 | 152 | 71 |
| P6 | 27 | 0 | 48 | 91 |
| P7 | 33 | 1 | 70 | 85 |
| P8 | 78 | 3 | 198 | 63 |
| P9 | 119 | 5 | 272 | 48 |
| Average | 39.1 | 1.1 | - | - |
| σ | 36.5 | 1.8 | - | - |
| σ/average | 0.93 | 1.63 | - | - |

### [Example 1: S (Sulfur)-doped InP Substrate (ϕ75 mm)]

### <Preparation of Group III-V Compound Semiconductor Single Crystal Substrate (InP Substrate)>

The preparing step, the polishing step, and the rough cleaning step and the precision cleaning step as the liquid phase treating step were each carried out in the same manner as in the preparation of the InP substrate of Comparative Example 1.

### (Vapor Phase Treating Step)

The InP substrate precursor that had undergone the liquid phase treating step was irradiated with ultraviolet radiation in an ozone atmosphere. Specifically, the InP substrate precursor was irradiated with ultraviolet radiation at 90°C for 5 minutes in an ozone atmosphere by using a vapor phase cleaning apparatus (trade name (product number): "UV Ozone Cleaner UV-1" manufactured by Samco Inc.).

### (Oxide Film Removing Step)

Next, the InP substrate precursor that had undergone the vapor phase treating step was immersed for 1 minute in a solution obtained by diluting buffered hydrofluoric acid (trade name (product number): "BHF-110U" manufactured by Daikin Industries, Ltd.) as a first solution including hydrofluoric acid and ammonium fluoride 100-fold with water (hydrofluoric acid concentration: 0.16% by mass, ammonium fluoride concentration: 0.27% by mass) to etch the oxide film on the main surface of the InP substrate precursor. Subsequently, this was subjected to running water cleaning with running ultra-pure water at room temperature (25°C) at a flow rate of 1 L/min. Furthermore, this was spin-dried for 2 minutes at a rotation speed of 800 rpm. An InP substrate of Example 1 was prepared as described above.

### <Measurement of First Particles and Second Particles on Main Surface of InP Substrate>

In the InP substrate of Example 1, the density of the first particles, the standard deviation/average value of the number of the first particles at measurement points P1 to P9, the density of the second particles, and the standard deviation/average value of the number of the second particles at measurement points P1 to P9 were determined in the same manner as in the measurement carried out in the InP substrate of Comparative Example 1.

The density of the first particles in the InP substrate of Example 1 was 2.2 /cm², and the density of the second particles was 0.00 /cm². The standard deviation/average value of the number of the first particles at measurement points P1 to P9 and the standard deviation/average value of the number of the second particles at measurement points P1 to P9 in the InP substrate of Example 1 are shown in Table 4.

### <Formation of Epitaxial Layer and Measurement of LPD>

An epitaxial layer-attached InP substrate of Example 1 was prepared in the same manner as was the epitaxial layer-attached InP substrate of Comparative Example 1. Furthermore, in the epitaxial layer-attached InP substrate of Example 1, the number of LPDs having a circle-equivalent diameter of 0.136 µm or more at measurement points corresponding to measurement points P1 to P9 was determined in the same manner as in the measurement carried out in the epitaxial layer-attached InP substrate of Comparative Example 1. The results are shown in Table 4. Table 4 also shows the device yield (%) of 100 devices each manufactured from a region including measurement points P1 to P9 on the substrate.

### [Table 4]

**Table. 4**

| Measurement point | Number of particles having particle size of 0.079 µm or more at measurement point (ϕ15 mm) on main surface of InP substrate (particles) | Number of particles having particle size of 0.19 µm or more at measurement point (ϕ15 mm) on main surface of InP substrate (particles) | Number of LPDs having circle-equivalent diameter of 0.136 µm or more at measurement point (ϕ15 mm) on main surface of epitaxial layer of epitaxial layer-attached InP substrate (defects) | Device yield (%) |
|---|---|---|---|---|
| P1 | 5 | 0 | 8 | 95 |
| P2 | 3 | 0 | 4 | 94 |
| P3 | 3 | 0 | 5 | 96 |
| P4 | 3 | 0 | 6 | 95 |
| P5 | 4 | 0 | 8 | 93 |
| P6 | 4 | 0 | 10 | 97 |
| P7 | 6 | 0 | 11 | 98 |
| P8 | 3 | 0 | 8 | 93 |
| P9 | 4 | 0 | 9 | 95 |
| Average | 3.9 | 0.0 | - | - |
| σ | 0.9 | 0.0 | - | - |
| σ/average | 0.23 | *0.00 | - | - |

| | | | | |
|---|---|---|---|---|
| * When the average is 0.0 and σ is 0.0, σ/average cannot be calculated, but it is assumed to be 0.00. | | | | |

### [Example 2: S (Sulfur)-doped InP Substrate (ϕ100 mm)]

### <Preparation of Group III-V Compound Semiconductor Single Crystal Substrate (InP Substrate)>

An InP substrate of Example 2 was prepared in the same manner as was the InP substrate of Example 1, except that an InP substrate precursor having a diameter of 100 mm (4 inches) having a main surface having a plane orientation of the {100} just plane was prepared in the preparing step.

### <Measurement of First Particles and Second Particles on Main Surface of InP Substrate>

In the InP substrate of Example 2, the density of the first particles, the standard deviation/average value of the number of the first particles at measurement points P1 to P9, the density of the second particles, and the standard deviation/average value of the number of the second particles at measurement points P1 to P9 were determined in the same manner as in the measurement carried out in the InP substrate of Comparative Example 1.

The density of the first particles in the InP substrate of Example 2 was 5.3 /cm², and the density of the second particles was 0.34 /cm². The standard deviation/average value of the number of the first particles at measurement points P1 to P9 and the standard deviation/average value of the number of the second particles at measurement points P1 to P9 in the InP substrate of Example 2 are shown in Table 5.

### <Formation of Epitaxial Layer and Measurement of LPD>

An epitaxial layer-attached InP substrate of Example 2 was prepared in the same manner as was the epitaxial layer-attached InP substrate of Comparative Example 1. Furthermore, in the epitaxial layer-attached InP substrate of Example 2, the number of LPDs having a circle-equivalent diameter of 0.136 µm or more at measurement points corresponding to measurement points P1 to P9 was determined in the same manner as in the measurement carried out in the epitaxial layer-attached InP substrate of Comparative Example 1. The results are shown in Table 5. Table 5 also shows the device yield (%) of 100 devices each manufactured from a region including measurement points P1 to P9 on the substrate.

### [Table 5]

**Table. 5**

| Measurement point | Number of particles having particle size of 0.079 µm or more at measurement point (ϕ15 mm) on main surface of InP substrate (particles) | Number of particles having particle size of 0.19 µm or more at measurement point (ϕ15 mm) on main surface of InP substrate (particles) | Number of LPDs having circle-equivalent diameter of 0.136 µm or more at measurement point (ϕ15 mm) on main surface of epitaxial layer of epitaxial layer-attached InP substrate (defects) | Device yield (%) |
|---|---|---|---|---|
| P1 | 13 | 1 | 29 | 95 |
| P2 | 4 | 0 | 5 | 94 |
| P3 | 2 | 1 | 3 | 97 |
| P4 | 2 | 0 | 5 | 97 |
| P5 | 2 | 0 | 8 | 98 |
| P6 | 15 | 1 | 29 | 92 |
| P7 | 15 | 1 | 36 | 92 |
| P8 | 18 | 1 | 24 | 95 |
| P9 | 12 | 0 | 26 | 94 |
| Average | 9.4 | 0.6 | - | - |
| σ | 6.7 | 0.5 | - | - |
| σ/average | 0.71 | 0.83 | - | - |

### [Example 3: S (Sulfur)-doped InP Substrate (ϕ150 mm)]

### <Preparation of Group III-V Compound Semiconductor Single Crystal Substrate (InP Substrate)>

An InP substrate of Example 3 was prepared in the same manner as was the InP substrate of Example 1, except that an InP substrate precursor having a diameter of 150 mm (6 inches) having a main surface having a plane orientation of the {100} just plane was prepared in the preparing step.

### <Measurement of First Particles and Second Particles on Main Surface of InP Substrate>

In the InP substrate of Example 3, the density of the first particles, the standard deviation/average value of the number of the first particles at measurement points P1 to P9, the density of the second particles, and the standard deviation/average value of the number of the second particles at measurement points P1 to P9 were determined in the same manner as in the measurement carried out in the InP substrate of Comparative

### Example 1.

The density of the first particles in the InP substrate of Example 3 was 10.7 /cm², and the density of the second particles was 0.40 /cm². The standard deviation/average value of the number of the first particles at measurement points P1 to P9 and the standard deviation/average value of the number of the second particles at measurement points P1 to P9 in the InP substrate of Example 3 are shown in Table 6.

### <Formation of Epitaxial Layer and Measurement of LPD>

An epitaxial layer-attached InP substrate of Example 3 was prepared in the same manner as was the epitaxial layer-attached InP substrate of Comparative Example 1. Furthermore, in the epitaxial layer-attached InP substrate of Example 3, the number of LPDs having a circle-equivalent diameter of 0.136 µm or more at measurement points corresponding to measurement points P1 to P9 was determined in the same manner as in the measurement carried out in the epitaxial layer-attached InP substrate of Comparative Example 1. The results are shown in Table 6. Table 6 also shows the device yield (%) of 100 devices each manufactured from a region including measurement points P1 to P9 on the substrate.

### [Table 6]

**Table. 6**

| Measurement point | Number of particles having particle size of 0.079 µm or more at measurement point (ϕ15 mm) on main surface of InP substrate (particles) | Number of particles having particle size of 0.19 µm or more at measurement point (ϕ15 mm) on main surface of InP substrate (particles) | Number of LPDs having circle-equivalent diameter of 0.136 µm or more at measurement point (ϕ15 mm) on main surface of epitaxial layer of epitaxial layer-attached InP substrate (defects) | Device yield (%) |
|---|---|---|---|---|
| P1 | 7 | 1 | 30 | 95 |
| P2 | 26 | 1 | 20 | 94 |
| P3 | 13 | 0 | 28 | 98 |
| P4 | 10 | 0 | 21 | 93 |
| P5 | 25 | 1 | 45 | 95 |
| P6 | 22 | 0 | 40 | 92 |
| P7 | 16 | 1 | 35 | 94 |
| P8 | 21 | 0 | 52 | 93 |
| P9 | 30 | 2 | 59 | 91 |
| Average | 18.9 | 0.7 | - | - |
| σ | 7.8 | 0.7 | - | - |
| σ/average | 0.41 | 1.00 | - | - |

### [Example 4: Fe (Iron)-doped InP Substrate (ϕ75 mm)]

### <Preparation of Group III-V Compound Semiconductor Single Crystal Substrate (InP Substrate)>

An InP substrate of Example 4 was prepared in the same manner as was the InP substrate of Example 1, except that an InP substrate precursor having a diameter of 75 mm (3 inches) having a main surface having a plane orientation of the {100} just plane was prepared from a semi-insulating InP single crystal doped with an Fe atom, manufactured by the VB method in the preparing step.

### <Measurement of First Particles and Second Particles on Main Surface of InP Substrate>

In the InP substrate of Example 4, the density of the first particles, the standard deviation/average value of the number of the first particles at measurement points P1 to P9, the density of the second particles, and the standard deviation/average value of the number of the second particles at measurement points P1 to P9 were determined in the same manner as in the measurement carried out in the InP substrate of Comparative Example 1.

The density of the first particles in the InP substrate of Example 4 was 5.1 /cm², and the density of the second particles was 0.23 /cm². The standard deviation/average value of the number of the first particles at measurement points P1 to P9 and the standard deviation/average value of the number of the second particles at measurement points P1 to P9 in the InP substrate of Example 4 are shown in Table 7.

### <Formation of Epitaxial Layer and Measurement of LPD>

An epitaxial layer-attached InP substrate of Example 4 was prepared in the same manner as was the epitaxial layer-attached InP substrate of Comparative Example 1. Furthermore, in the epitaxial layer-attached InP substrate of Example 4, the number of LPDs having a circle-equivalent diameter of 0.136 µm or more at measurement points corresponding to measurement points P1 to P9 was determined in the same manner as in the measurement carried out in the epitaxial layer-attached InP substrate of Comparative Example 1. The results are shown in Table 7. Table 7 also shows the device yield (%) of 100 devices each manufactured from a region including measurement points P1 to P9 on the substrate.

### [Table 7]

**Table. 7**

| Measurement point | Number of particles having particle size of 0.079 µm or more at measurement point (ϕ15 mm) on main surface of InP substrate (particles) | Number of particles having particle size of 0.19 µm or more at measurement point (ϕ15 mm) on main surface of InP substrate (particles) | Number of LPDs having circle-equivalent diameter of 0.136 µm or more at measurement point (ϕ15 mm) on main surface of epitaxial layer of epitaxial layer-attached InP substrate (defects) | Device yield (%) |
|---|---|---|---|---|
| P1 | 11 | 1 | 12 | 95 |
| P2 | 6 | 0 | 15 | 92 |
| P3 | 8 | 1 | 14 | 93 |
| P4 | 7 | 0 | 19 | 97 |
| P5 | 9 | 0 | 20 | 96 |
| P6 | 10 | 1 | 26 | 96 |
| P7 | 13 | 1 | 15 | 95 |
| P8 | 7 | 0 | 16 | 92 |
| P9 | 8 | 0 | 22 | 93 |
| Average | 9.0 | 0.4 | - | - |
| σ | 2.2 | 0.5 | - | - |
| σ/average | 0.24 | 1.25 | - | - |

### [Example 5: Fe (Iron)-doped InP Substrate (ϕ100 mm)]

### <Preparation of Group III-V Compound Semiconductor Single Crystal Substrate (InP Substrate)>

An InP substrate of Example 5 was prepared in the same manner as was the InP substrate of Example 4, except that an InP substrate precursor having a diameter of 100 mm (4 inches) having a main surface having a plane orientation of the {100} just plane was prepared in the preparing step.

### <Measurement of First Particles and Second Particles on Main Surface of InP Substrate>

In the InP substrate of Example 5, the density of the first particles, the standard deviation/average value of the number of the first particles at measurement points P1 to P9, the density of the second particles, and the standard deviation/average value of the number of the second particles at measurement points P1 to P9 were determined in the same manner as in the measurement carried out in the InP substrate of Comparative

### Example 1.

The density of the first particles in the InP substrate of Example 5 was 7.7 /cm², and the density of the second particles was 0.23 /cm². The standard deviation/average value of the number of the first particles at measurement points P1 to P9 and the standard deviation/average value of the number of the second particles at measurement points P1 to P9 in the InP substrate of Example 5 are shown in Table 8.

### <Formation of Epitaxial Layer and Measurement of LPD>

An epitaxial layer-attached InP substrate of Example 5 was prepared in the same manner as was the epitaxial layer-attached InP substrate of Comparative Example 1. Furthermore, in the epitaxial layer-attached InP substrate of Example 5, the number of LPDs having a circle-equivalent diameter of 0.136 µm or more at measurement points corresponding to measurement points P1 to P9 was determined in the same manner as in the measurement carried out in the epitaxial layer-attached InP substrate of Comparative Example 1. The results are shown in Table 8. Table 8 also shows the device yield (%) of 100 devices each manufactured from a region including measurement points P1 to P9 on the substrate.

### [Table 8]

**Table. 8**

| Measurement point | Number of particles having particle size of 0.079 µm or more at measurement point (ϕ15 mm) on main surface of InP substrate (particles) | Number of particles having particle size of 0.19 µm or more at measurement point (ϕ15 mm) on main surface of InP substrate (particles) | Number of LPDs having circle-equivalent diameter of 0.136 µm or more at measurement point (ϕ15 mm) on main surface of epitaxial layer of epitaxial layer-attached InP substrate (defects) | Device yield (%) |
|---|---|---|---|---|
| P1 | 13 | 0 | 18 | 97 |
| P2 | 7 | 0 | 31 | 93 |
| P3 | 9 | 0 | 15 | 95 |
| P4 | 15 | 1 | 25 | 95 |
| P5 | 5 | 0 | 23 | 94 |
| P6 | 15 | 0 | 37 | 94 |
| P7 | 22 | 1 | 45 | 95 |
| P8 | 18 | 1 | 26 | 93 |
| P9 | 18 | 1 | 49 | 92 |
| Average | 13.6 | 0.4 | - | - |
| σ | 5.6 | 0.5 | - | - |
| σ/average | 0.41 | 1 .25 | - | - |

### [Example 6: Fe (Iron)-doped InP Substrate (ϕ150 mm)]

### <Preparation of Group III-V Compound Semiconductor Single Crystal Substrate (InP Substrate)>

An InP substrate of Example 6 was prepared in the same manner as was the InP substrate of Example 4, except that an InP substrate precursor having a diameter of 150 mm (6 inches) having a main surface having a plane orientation of the {100} just plane was prepared in the preparing step.

### <Measurement of First Particles and Second Particles on Main Surface of InP Substrate>

In the InP substrate of Example 6, the density of the first particles, the standard deviation/average value of the number of the first particles at measurement points P1 to P9, the density of the second particles, and the standard deviation/average value of the number of the second particles at measurement points P1 to P9 were determined in the same manner as in the measurement carried out in the InP substrate of Comparative

### Example 1.

The density of the first particles in the InP substrate of Example 6 was 12.3 /cm², and the density of the second particles was 0.62 /cm². The standard deviation/average value of the number of the first particles at measurement points P1 to P9 and the standard deviation/average value of the number of the second particles at measurement points P1 to P9 in the InP substrate of Example 6 are shown in Table 9.

### <Formation of Epitaxial Layer and Measurement of LPD>

An epitaxial layer-attached InP substrate of Example 6 was prepared in the same manner as was the epitaxial layer-attached InP substrate of Comparative Example 1. Furthermore, in the epitaxial layer-attached InP substrate of Example 6, the number of LPDs having a circle-equivalent diameter of 0.136 µm or more at measurement points corresponding to measurement points P1 to P9 was determined in the same manner as in the measurement carried out in the epitaxial layer-attached InP substrate of Comparative Example 1. The results are shown in Table 9. Table 9 also shows the device yield (%) of 100 devices each manufactured from a region including measurement points P1 to P9 on the substrate.

### [Table 9]

**Table. 9**

| Measurement point | Number of particles having particle size of 0.079 µm or more at measurement point (ϕ15 mm) on main surface of InP substrate (particles) | Number of particles having particle size of 0.19 µm or more at measurement point (ϕ15 mm) on main surface of InP substrate (particles) | Number of LPDs having circle-equivalent diameter of 0.136 µm or more at measurement point (ϕ15 mm) on main surface of epitaxial layer of epitaxial layer-attached InP substrate (defects) | Device yield (%) |
|---|---|---|---|---|
| P1 | 17 | 1 | 21 | 94 |
| P2 | 20 | 1 | 29 | 91 |
| P3 | 37 | 3 | 45 | 91 |
| P4 | 15 | 1 | 35 | 93 |
| P5 | 10 | 0 | 25 | 92 |
| P6 | 32 | 2 | 40 | 90 |
| P7 | 16 | 0 | 32 | 92 |
| P8 | 21 | 1 | 43 | 93 |
| P9 | 27 | 1 | 51 | 90 |
| Average | 21.7 | 1.1 | - | - |
| σ | 8.7 | 0.9 | - | - |
| σ/average | 0.41 | 0.82 | - | - |

### [Example 7: Sn (Tin)-doped InP Substrate (ϕ75 mm)]

### <Preparation of Group III-V Compound Semiconductor Single Crystal Substrate (InP Substrate)>

An InP substrate of Example 7 was prepared in the same manner as was the InP substrate of Example 1, except that an InP substrate precursor having a diameter of 75 mm (3 inches) having a main surface having a plane orientation of the {100} just plane was prepared from a conductive InP single crystal doped with a Sn atom, manufactured by the VB method in the preparing step.

### <Measurement of First Particles and Second Particles on Main Surface of InP Substrate>

In the InP substrate of Example 7, the density of the first particles, the standard deviation/average value of the number of the first particles at measurement points P1 to P9, the density of the second particles, and the standard deviation/average value of the number of the second particles at measurement points P1 to P9 were determined in the same manner as in the measurement carried out in the InP substrate of Comparative Example 1.

The density of the first particles in the InP substrate of Example 7 was 2.8 /cm², and the density of the second particles was 0.00 /cm². The standard deviation/average value of the number of the first particles at measurement points P1 to P9 and the standard deviation/average value of the number of the second particles at measurement points P1 to P9 in the InP substrate of Example 7 are shown in Table 10.

### <Formation of Epitaxial Layer and Measurement of LPD>

An epitaxial layer-attached InP substrate of Example 7 was prepared in the same manner as was the epitaxial layer-attached InP substrate of Comparative Example 1. Furthermore, in the epitaxial layer-attached InP substrate of Example 7, the number of LPDs having a circle-equivalent diameter of 0.136 µm or more at measurement points corresponding to measurement points P1 to P9 was determined in the same manner as in the measurement carried out in the epitaxial layer-attached InP substrate of Comparative Example 1. The results are shown in Table 10. Table 10 also shows the device yield (%) of 100 devices each manufactured from a region including measurement points P1 to P9 on the substrate.

### [Table 10]

**Table. 10**

| Measurement point | Number of particles having particle size of 0.079 µm or more at measurement point (ϕ15 mm) on main surface of InP substrate (particles) | Number of particles having particle size of 0.19 µm or more at measurement point (ϕ15 mm) on main surface of InP substrate (particles) | Number of LPDs having circle-equivalent diameter of 0.136 µm or more at measurement point (ϕ15 mm) on main surface of epitaxial layer of epitaxial layer-attached InP substrate (defects) | Device yield (%) |
|---|---|---|---|---|
| P1 | 6 | 0 | 10 | 96 |
| P2 | 3 | 0 | 10 | 93 |
| P3 | 5 | 0 | 9 | 94 |
| P4 | 5 | 0 | 12 | 96 |
| P5 | 4 | 0 | 12 | 91 |
| P6 | 6 | 0 | 16 | 92 |
| P7 | 4 | 0 | 7 | 94 |
| P8 | 7 | 0 | 16 | 97 |
| P9 | 5 | 0 | 17 | 95 |
| Average | 4.9 | 0.0 | - | - |
| σ | 1.2 | 0.0 | - | - |
| σ/average | 0.24 | *0.00 | - | - |

| | | | | |
|---|---|---|---|---|
| * When the average is 0.0 and σ is 0.0, σ/average cannot be calculated, but it is assumed to be 0.00. | | | | |

### [Example 8: Zn (Zinc)-doped InP Substrate (ϕ100 mm)]

### <Preparation of Group III-V Compound Semiconductor Single Crystal Substrate (InP Substrate)>

An InP substrate of Example 8 was prepared in the same manner as was the InP substrate of Example 1, except that an InP substrate precursor having a diameter of 100 mm (4 inches) having a main surface having a plane orientation of the {100} just plane was prepared from a conductive InP single crystal doped with a Zn atom, manufactured by the VB method in the preparing step.

### <Measurement of First Particles and Second Particles on Main Surface of InP Substrate>

In the InP substrate of Example 8, the density of the first particles, the standard deviation/average value of the number of the first particles at measurement points P1 to P9, the density of the second particles, and the standard deviation/average value of the number of the second particles at measurement points P1 to P9 were determined in the same manner as in the measurement carried out in the InP substrate of Comparative Example 1.

The density of the first particles in the InP substrate of Example 8 was 6.3 /cm², and the density of the second particles was 0.00 /cm². The standard deviation/average value of the number of the first particles at measurement points P1 to P9 and the standard deviation/average value of the number of the second particles at measurement points P1 to P9 in the InP substrate of Example 8 are shown in Table 11.

### <Formation of Epitaxial Layer and Measurement of LPD>

An epitaxial layer-attached InP substrate of Example 8 was prepared in the same manner as was the epitaxial layer-attached InP substrate of Comparative Example 1. Furthermore, in the epitaxial layer-attached InP substrate of Example 8, the number of LPDs having a circle-equivalent diameter of 0.136 µm or more at measurement points corresponding to measurement points P1 to P9 was determined in the same manner as in the measurement carried out in the epitaxial layer-attached InP substrate of Comparative Example 1. The results are shown in Table 11. Table 11 also shows the device yield (%) of 100 devices each manufactured from a region including measurement points P1 to P9 on the substrate.

### [Table 11]

**Table. 11**

| Measurement point | Number of particles having particle size of 0.079 µm or more at measurement point (ϕ15 mm) on main surface of InP substrate (particles) | Number of particles having particle size of 0.19 µm or more at measurement point (<p15 mm) on main surface of InP substrate (particles) | Number of LPDs having circle-equivalent diameter of 0.136 µm or more at measurement point (ϕ15 mm) on main surface of epitaxial layer of epitaxial layer-attached InP substrate (defects) | Device yield (%) |
|---|---|---|---|---|
| P1 | 11 | 0 | 20 | 94 |
| P2 | 4 | 0 | 10 | 95 |
| P3 | 12 | 0 | 19 | 96 |
| P4 | 6 | 0 | 15 | 94 |
| P5 | 8 | 0 | 12 | 95 |
| P6 | 20 | 0 | 39 | 94 |
| P7 | 12 | 0 | 36 | 93 |
| P8 | 13 | 0 | 20 | 91 |
| P9 | 15 | 0 | 26 | 92 |
| Average | 11.2 | 0.0 | - | - |
| σ | 4.8 | 0.0 | - | - |
| σ/average | 0.43 | *0.00 | - | - |

| | | | | |
|---|---|---|---|---|
| * When the average is 0.0 and σ is 0.0, σ/average cannot be calculated, but it is assumed to be 0.00. | | | | |

### [Comparative Example 4: Si (Silicon)-doped GaAs Substrate (ϕ75 mm)]

### <Preparation of Group III-V Compound Semiconductor Single Crystal Substrate (GaAs Substrate)>

### (Preparing Step)

A conductive GaAs single crystal doped with a Si atom, manufactured by the VB method was sliced and chamfered to prepare a GaAs substrate precursor having a diameter of 75 mm (3 inches) having a main surface having a plane orientation of the { 100} just plane. In addition, an orientation flat was formed on the outer periphery of the main surface of the GaAs substrate precursor in the crystal orientation [010] direction.

### (Polishing Step)

The main surface of the GaAs substrate precursor was polished by mechanical polishing and chemical mechanical polishing (CMP) to a mirror surface where the arithmetic average roughness Ra of the main surface defined by JIS B0601: 2001 was 0.3 nm or less.

### (Liquid Phase Treating Step: Rough Cleaning Step)

The GaAs substrate precursor that had undergone the polishing step was immersed in a 0.5% by volume tetramethylammonium hydroxide aqueous solution at room temperature (25°C) for 5 minutes in the vertical-batch method. Furthermore, the GaAs substrate precursor was rinsed with ultra-pure water (electric resistivity (specific resistance): 18 MΩ·cm or more, TOC (total organic carbon): less than 10 µg/L (liter), and number of fine particles: less than 100 particles/L (liter)) for 3 minutes. Subsequently, the GaAs substrate precursor was again immersed in a 0.5% by volume tetramethylammonium hydroxide aqueous solution at room temperature (25°C) for 5 minutes, and rinsed with ultra-pure water for 3 minutes. Thereby, the GaAs substrate precursor was roughly cleaned.

### (Liquid Phase Treating Step: Precision Cleaning Step)

The GaAs substrate precursor that had undergone the rough cleaning step was precisely cleaned by the face down single wafer method. Specifically, the GaAs substrate precursor was precisely cleaned by acid cleaning, ultra-pure water rinsing twice, and drying. In the acid cleaning, 1 L (liter) of a nitric acid aqueous solution having a pH of 5 was supplied to the main surface of the GaAs substrate precursor at room temperature (25°C) over 1 minute, and in the ultra-pure water rinsing, 1 L (liter) of ultra-pure water was supplied to the main surface of the GaAs substrate precursor at room temperature (25°C) over 1 minute. Furthermore, in the drying, centrifugal shake-off drying was carried out. By carrying out the above cleaning step, a GaAs substrate of Comparative Example 4 was obtained from the GaAs substrate precursor.

### <Measurement of First Particles on Main Surface of GaAs Substrate>

In the GaAs substrate, a first region that was a circular region inside a first virtual line passing through a point 5 mm away inward from the outer periphery of the main surface was selected as the measurement target, and first, the standard deviation/average value of the number of first particles was determined. Specifically, by using the above wafer surface inspection apparatus (trade name (product number): "WM-10" manufactured by Takano Co., Ltd.), the number of first particles was measured at each of measurement points at nine points in total, where the measurement points at the nine points were P1 to P9 consisting of a measurement point P1 at one point at the center of the main surface, measurement points P2, P3, P4, and P5 at four midpoints of four virtual line segments having angles of 0 degrees, 90 degrees, 180 degrees, and 270 degrees, respectively, with respect to a first reference line that is a virtual line segment extending from the center of the main surface to the first virtual line in a direction going from the center of the main surface toward an orientation flat and extending from the center to the first virtual line, and measurement points P6, P7, P8, and P9 at four endpoints of four virtual line segments having angles of 45 degrees, 135 degrees, 225 degrees, and 315 degrees, respectively, with respect to the first reference line and extending from the center to the first virtual line, and the standard deviation/the average value of the number of the first particles was determined based on measurement results thereof (see Fig. 1 for the positions of measurement points P1 to P9). The results are shown in Table 12. The conditions for measuring the number of the first particles by using the above wafer surface inspection apparatus (trade name (product number): "WM-10" manufactured by Takano Co., Ltd.) are the same as the conditions for measuring the number of the first particles in Comparative Example 1.

Next, the first region was targeted, and the average value of the number of the first particles obtained from measurement points P1 to P9 was converted into the number of the first particles per cm² to determine the density of the first particles on the main surface. As a result, the density of the first particles was 2.2 /cm².

### <Formation of Epitaxial Layer and Measurement of LPD>

Next, on the main surface of the GaAs substrate, an Al_{0.5}Ga_{0.5}As layer having a thickness of 0.3 µm was grown as an epitaxial layer by the MOVPE method. Thereby, an epitaxial layer-attached GaAs substrate of Comparative Example 4 was prepared.

In the epitaxial layer of the epitaxial layer-attached GaAs substrate, a region corresponding to the first region of the GaAs substrate (that is, a circular region inside a second virtual line passing through a point 5 mm away inward from the outer periphery of the main surface of the epitaxial layer) was selected as the measurement target, and the number of LPDs having a circle-equivalent diameter of 0.136 µm or more was measured by using the above wafer surface inspection apparatus (trade name (product number): "WM-10" manufactured by Takano Co., Ltd.). Specifically, the number of LPDs having a circle-equivalent diameter of 0.136 µm or more was determined at measurement points corresponding to measurement points P1 to P9 on the main surface of the GaAs substrate (that is, measurement points at nine points in total consisting of a measurement point at one point at the center of the main surface of the epitaxial layer of the epitaxial layer-attached GaAs substrate, measurement points at four midpoints of four virtual line segments having angles of 0 degrees, 90 degrees, 180 degrees, and 270 degrees, respectively, with respect to a second reference line that is a virtual line segment extending from the center of the main surface to the second virtual line in a direction going from the center of the main surface toward an orientation flat and extending from the center to the second virtual line, and measurement points at four endpoints of four virtual line segments having angles of 45 degrees, 135 degrees, 225 degrees, and 315 degrees, respectively, with respect to the second reference line and extending from the center to the second virtual line). The results are shown in Table 12. Table 12 also shows the device yield (%) of 100 devices each manufactured from a region including the measurement points at the nine points in total on the substrate. The conditions for measuring the number of LPDs having a circle-equivalent diameter of 0.136 µm or more by using the wafer surface inspection apparatus (trade name (product number): "WM-10" manufactured by Takano Co., Ltd.) are the same as the conditions for the first particles.

### [Table 12]

**Table. 12**

| Measurement point | Number of particles having particle size of 0.079 µm or more at measurement point (ϕ15 mm) on main surface of GaAs substrate (particles) | Number of LPDs having circle-equivalent diameter of 0.136 µm or more at measurement point (ϕ15 mm) on main surface of epitaxial layer of epitaxial layer-attached GaAs substrate (defects) | Device yield (%) |
|---|---|---|---|
| P1 | 1 | 33 | 90 |
| P2 | 9 | 121 | 83 |
| P3 | 4 | 101 | 89 |
| P4 | 1 | 57 | 85 |
| P5 | 0 | 21 | 94 |
| P6 | 4 | 144 | 82 |
| P7 | 4 | 161 | 78 |
| P8 | 12 | 165 | 83 |
| P9 | 0 | 21 | 92 |
| Average | 3.9 | - | - |
| σ | 4.2 | - | - |
| σ/average | 1.07 | - | - |

### [Comparative Example 5: Si (Silicon)-doped GaAs Substrate (ϕ100 mm)]

### <Preparation of Group III-V Compound Semiconductor Single Crystal Substrate (GaAs Substrate)>

A GaAs substrate of Comparative Example 5 was prepared in the same manner as was the GaAs substrate of Comparative Example 4, except that a GaAs substrate precursor having a diameter of 100 mm (4 inches) having a main surface having a plane orientation of the {100} just plane was prepared in the preparing step.

### <Measurement of First Particles on Main Surface of GaAs Substrate>

In the GaAs substrate of Comparative Example 5, the density of the first particles and the standard deviation/average value of the number of the first particles at measurement points P1 to P9 were each determined in the same manner as in the measurement carried out in the GaAs substrate of Comparative Example 4.

The density of the first particles in the GaAs substrate of Comparative Example 5 was 2.3 /cm². The standard deviation/average value of the number of the first particles at measurement points P1 to P9 in the GaAs substrate of Comparative Example 5 is shown in Table 13.

### <Formation of Epitaxial Layer and Measurement of LPD>

An epitaxial layer-attached GaAs substrate of Comparative Example 5 was prepared in the same manner as was the epitaxial layer-attached GaAs substrate of Comparative Example 4. Furthermore, in the epitaxial layer-attached GaAs substrate of Comparative Example 5, the number of LPDs having a circle-equivalent diameter of 0.136 µm or more at measurement points corresponding to measurement points P1 to P9 was determined in the same manner as in the measurement carried out in the epitaxial layer-attached GaAs substrate of Comparative Example 4. The results are shown in Table 13. Table 13 also shows the device yield (%) of 100 devices each manufactured from a region including measurement points P1 to P9 on the substrate.

### [Table 13]

**Table. 13**

| Measurement point | Number of particles having particle size of 0.079 µm or more at measurement point (ϕ15 mm) on main surface of GaAs substrate (particles) | Number of LPDs having circle-equivalent diameter of 0.136 µm or more at measurement point (ϕ15 mm) on main surface of epitaxial layer of epitaxial layer-attached GaAs substrate (defects) | Device yield (%) |
|---|---|---|---|
| P1 | 2 | 74 | 95 |
| P2 | 0 | 10 | 92 |
| P3 | 0 | 13 | 93 |
| P4 | 7 | 116 | 93 |
| P5 | 9 | 201 | 80 |
| P6 | 6 | 165 | 77 |
| P7 | 0 | 20 | 92 |
| P8 | 0 | 11 | 92 |
| P9 | 12 | 211 | 70 |
| Average | 4.0 | - | - |
| σ | 4.6 | - | - |
| σ/average | 1.15 | - | - |

### [Comparative Example 6: Si (Silicon)-doped GaAs Substrate (ϕ150 mm)]

### <Preparation of Group III-V Compound Semiconductor Single Crystal Substrate (GaAs Substrate)>

A GaAs substrate of Comparative Example 6 was prepared in the same manner as was the GaAs substrate of Comparative Example 4, except that a GaAs substrate precursor having a diameter of 150 mm (6 inches) having a main surface having a plane orientation of the {100} just plane was prepared in the preparing step.

### <Measurement of First Particles on Main Surface of GaAs Substrate>

In the GaAs substrate of Comparative Example 6, the density of the first particles and the standard deviation/average value of the number of the first particles at measurement points P1 to P9 were each determined in the same manner as in the measurement carried out in the GaAs substrate of Comparative Example 4.

The density of the first particles in the GaAs substrate of Comparative Example 6 was 1.0 /cm². The standard deviation/average value of the number of the first particles at measurement points P1 to P9 in the GaAs substrate of Comparative Example 6 is shown in Table 14.

### <Formation of Epitaxial Layer and Measurement of LPD>

An epitaxial layer-attached GaAs substrate of Comparative Example 6 was prepared in the same manner as was the epitaxial layer-attached GaAs substrate of Comparative Example 4. Furthermore, in the epitaxial layer-attached GaAs substrate of Comparative Example 6, the number of LPDs having a circle-equivalent diameter of 0.136 µm or more at measurement points corresponding to measurement points P1 to P9 was determined in the same manner as in the measurement carried out in the epitaxial layer-attached GaAs substrate of Comparative Example 4. The results are shown in Table 14. Table 14 also shows the device yield (%) of 100 devices each manufactured from a region including measurement points P1 to P9 on the substrate.

### [Table 14]

**Table. 14**

| Measurement point | Number of particles having particle size of 0.079 µm or more at measurement point (ϕ15 mm) on main surface of GaAs substrate (particles) | Number of LPDs having circle-equivalent diameter of 0.136 µm or more at measurement point (ϕ15 mm) on main surface of epitaxial layer of epitaxial layer-attached GaAs substrate (defects) | Device yield (%) |
|---|---|---|---|
| P1 | 0 | 29 | 94 |
| P2 | 0 | 24 | 95 |
| P3 | 1 | 11 | 94 |
| P4 | 6 | 150 | 83 |
| P5 | 0 | 41 | 92 |
| P6 | 4 | 201 | 71 |
| P7 | 1 | 70 | 85 |
| P8 | 3 | 106 | 82 |
| P9 | 0 | 24 | 85 |
| Average | 1.7 | - | - |
| σ | 2.2 | - | - |
| σ/average | 1.29 | - | - |

### [Comparative Example 7: Si (Silicon)-doped GaAs Substrate (ϕ200 mm)]

### <Preparation of Group III-V Compound Semiconductor Single Crystal Substrate (GaAs Substrate)>

A GaAs substrate of Comparative Example 7 was prepared in the same manner as was the GaAs substrate of Comparative Example 4, except that a GaAs substrate precursor having a diameter of 200 mm (8 inches) having a main surface having a plane orientation of the {100} just plane was prepared in the preparing step.

### <Measurement of First Particles on Main Surface of GaAs Substrate>

In the GaAs substrate of Comparative Example 7, the density of the first particles and the standard deviation/average value of the number of the first particles at measurement points P1 to P9 were each determined in the same manner as in the measurement carried out in the GaAs substrate of Comparative Example 4.

The density of the first particles in the GaAs substrate of Comparative Example 7 was 5.0 /cm². The standard deviation/average value of the number of the first particles at measurement points P1 to P9 in the GaAs substrate of Comparative Example 7 is shown in Table 15.

### <Formation of Epitaxial Layer and Measurement of LPD>

An epitaxial layer-attached GaAs substrate of Comparative Example 7 was prepared in the same manner as was the epitaxial layer-attached GaAs substrate of Comparative Example 4. Furthermore, in the epitaxial layer-attached GaAs substrate of Comparative Example 7, the number of LPDs having a circle-equivalent diameter of 0.136 µm or more at measurement points corresponding to measurement points P1 to P9 was determined in the same manner as in the measurement carried out in the epitaxial layer-attached GaAs substrate of Comparative Example 4. The results are shown in Table 15. Table 15 also shows the device yield (%) of 100 devices each manufactured from a region including measurement points P1 to P9 on the substrate.

### [Table 15]

**Table. 15**

| Measurement point | Number of particles having particle size of 0.079 µm or more at measurement point (ϕ15 mm) on main surface of GaAs substrate (particles) | Number of LPDs having circle-equivalent diameter of 0.136 µm or more at measurement point (ϕ15 mm) on main surface of epitaxial layer of epitaxial layer-attached GaAs substrate (defects) | Device yield (%) |
|---|---|---|---|
| P1 | 3 | 29 | 94 |
| P2 | 0 | 24 | 95 |
| P3 | 10 | 101 | 94 |
| P4 | 7 | 208 | 75 |
| P5 | 32 | 466 | 55 |
| P6 | 2 | 78 | 91 |
| P7 | 11 | 320 | 61 |
| P8 | 10 | 198 | 83 |
| P9 | 5 | 106 | 91 |
| Average | 8.9 | - | - |
| σ | 9.5 | - | - |
| σ/average | 1.07 | - | - |

### [Example 9: Si (Silicon)-doped GaAs Substrate (cp75 mm)]

### <Preparation of Group III-V Compound Semiconductor Single Crystal Substrate (GaAs Substrate)>

The preparing step, the polishing step, and the rough cleaning step and the precision cleaning step as the liquid phase treating step were each carried out in the same manner as in the preparation of the GaAs substrate of Comparative Example 4.

### (Vapor Phase Treating Step)

The GaAs substrate precursor that had undergone the liquid phase treating step was irradiated with ultraviolet radiation in an ozone atmosphere or in an oxygen-containing atmosphere. Specifically, the GaAs substrate precursor was irradiated with ultraviolet radiation at 90°C for 5 minutes in an ozone atmosphere by using a vapor phase cleaning apparatus (trade name (product number): "UV Ozone Cleaner UV-1" manufactured by Samco Inc.).

### (Oxide Film Removing Step)

Next, the GaAs substrate precursor that had undergone the vapor phase treating step was immersed for 1 minute in a solution obtained by diluting buffered hydrofluoric acid (trade name (product number): "BHF-110U" manufactured by Daikin Industries, Ltd.) as a first solution containing hydrofluoric acid and ammonium fluoride 100-fold with water (hydrofluoric acid concentration: 0.16% by mass, ammonium fluoride concentration: 0.27% by mass) to etch the oxide film on the main surface of the InP substrate precursor. Subsequently, this was subjected to running water cleaning with running ultra-pure water at room temperature (25°C) at a flow rate of 1 L/min. Furthermore, this was spin-dried for 2 minutes at a rotation speed of 800 rpm. A GaAs substrate of Example 9 was prepared as described above.

### <Measurement of First Particles on Main Surface of GaAs Substrate>

In the GaAs substrate of Example 9, the density of the first particles and the standard deviation/average value of the number of the first particles at measurement points P1 to P9 were each determined in the same manner as in the measurement carried out in the GaAs substrate of Comparative Example 4.

The density of the first particles in the GaAs substrate of Example 9 was 0.5 /cm². The standard deviation/average value of the number of the first particles at measurement points P1 to P9 in the GaAs substrate of Example 9 is shown in Table 16.

### <Formation of Epitaxial Layer and Measurement of LPD>

An epitaxial layer-attached GaAs substrate of Example 9 was prepared in the same manner as was the epitaxial layer-attached GaAs substrate of Comparative Example 4. Furthermore, in the epitaxial layer-attached GaAs substrate of Example 9, the number of LPDs having a circle-equivalent diameter of 0.136 µm or more at measurement points corresponding to measurement points P1 to P9 was determined in the same manner as in the measurement carried out in the epitaxial layer-attached GaAs substrate of Comparative Example 4. The results are shown in Table 16. Table 16 also shows the device yield (%) of 100 devices each manufactured from a region including measurement points P1 to P9 on the substrate.

### [Table 16]

**Table. 16**

| Measurement point | Number of particles having particle size of 0.079 µm or more at measurement point (ϕ15 mm) on main surface of GaAs substrate (particles) | Number of LPDs having circle-equivalent diameter of 0.136 µm or more at measurement point (ϕ15 mm) on main surface of epitaxial layer of epitaxial layer-attached GaAs substrate (defects) | Device yield (%) |
|---|---|---|---|
| P1 | 1 | 10 | 90 |
| P2 | 0 | 9 | 92 |
| P3 | 1 | 19 | 93 |
| P4 | 0 | 15 | 95 |
| P5 | 1 | 21 | 94 |
| P6 | 2 | 65 | 86 |
| P7 | 1 | 55 | 90 |
| P8 | 2 | 98 | 85 |
| P9 | 0 | 42 | 92 |
| Average | 0.9 | - | - |
| σ | 0.8 | - | - |
| σ/average | 0.89 | - | - |

### [Example 10: Si (Silicon)-doped GaAs Substrate (ϕ100 mm)]

### <Preparation of Group III-V Compound Semiconductor Single Crystal Substrate (GaAs Substrate)>

A GaAs substrate of Example 10 was prepared in the same manner as was the GaAs substrate of Example 9, except that a GaAs substrate precursor having a diameter of 100 mm (4 inches) having a main surface having a plane orientation of the {100} just plane was prepared in the preparing step.

### <Measurement of First Particles on Main Surface of GaAs Substrate>

In the GaAs substrate of Example 10, the density of the first particles and the standard deviation/average value of the number of the first particles at measurement points P1 to P9 were each determined in the same manner as in the measurement carried out in the GaAs substrate of Comparative Example 4.

The density of the first particles in the GaAs substrate of Example 10 was 1.0 /cm². The standard deviation/average value of the number of the first particles at measurement points P1 to P9 in the GaAs substrate of Example 10 is shown in Table 17.

### <Formation of Epitaxial Layer and Measurement of LPD>

An epitaxial layer-attached GaAs substrate of Example 10 was prepared in the same manner as was the epitaxial layer-attached GaAs substrate of Comparative Example 4. Furthermore, in the epitaxial layer-attached GaAs substrate of Example 10, the number of LPDs having a circle-equivalent diameter of 0.136 µm or more at measurement points corresponding to measurement points P1 to P9 was determined in the same manner as in the measurement carried out in the epitaxial layer-attached GaAs substrate of Comparative Example 4. The results are shown in Table 17. Table 17 also shows the device yield (%) of 100 devices each manufactured from a region including measurement points P1 to P9 on the substrate.

### [Table 17]

**Table. 17**

| Measurement point | Number of particles having particle size of 0.079 µm or more at measurement point (ϕ15 mm) on main surface of GaAs substrate (particles) | Number of LPDs having circle-equivalent diameter of 0.136 µm or more at measurement point (ϕ15 mm) on main surface of epitaxial layer of epitaxial layer-attached GaAs substrate (defects) | Device yield (%) |
|---|---|---|---|
| P1 | 0 | 10 | 90 |
| P2 | 0 | 9 | 92 |
| P3 | 2 | 52 | 93 |
| P4 | 3 | 66 | 95 |
| P5 | 0 | 21 | 94 |
| P6 | 2 | 32 | 91 |
| P7 | 4 | 55 | 90 |
| P8 | 3 | 88 | 89 |
| P9 | 1 | 42 | 92 |
| Average | 1.7 | - | - |
| σ | 1.5 | - | - |
| σ/average | 0.88 | - | - |

### [Example 11: Si (Silicon)-doped GaAs Substrate (ϕ150 mm)]

### <Preparation of Group III-V Compound Semiconductor Single Crystal Substrate (GaAs Substrate)>

A GaAs substrate of Example 11 was prepared in the same manner as was the GaAs substrate of Example 9, except that a GaAs substrate precursor having a diameter of 1 50 mm (6 inches) having a main surface having a plane orientation of the {100} just plane was prepared in the preparing step.

### <Measurement of First Particles on Main Surface of GaAs Substrate>

In the GaAs substrate of Example 11, the density of the first particles and the standard deviation/average value of the number of the first particles at measurement points P1 to P9 were each determined in the same manner as the measurement carried out in the GaAs substrate of Comparative Example 4.

The density of the first particles in the GaAs substrate of Example 11 was 0.5 /cm². The standard deviation/average value of the number of the first particles at measurement points P1 to P9 in the GaAs substrate of Example 11 is shown in Table 18.

### <Formation of Epitaxial Layer and Measurement of LPD>

An epitaxial layer-attached GaAs substrate of Example 11 was prepared in the same manner as was the epitaxial layer-attached GaAs substrate of Comparative Example 4. Furthermore, in the epitaxial layer-attached GaAs substrate of Example 11, the number of LPDs having a circle-equivalent diameter of 0.136 µm or more at measurement points corresponding to measurement points P1 to P9 was determined in the same manner as in the measurement carried out in the epitaxial layer-attached GaAs substrate of Comparative Example 4. The results are shown in Table 18. Table 18 also shows the device yield (%) of 100 devices each manufactured from a region including measurement points P1 to P9 on the substrate.

### [Table 18]

**Table. 18**

| Measurement point | Number of particles having particle size of 0.079 µm or more at measurement point (ϕ15 mm) on main surface of GaAs substrate (particles) | Number of LPDs having circle-equivalent diameter of 0.136 µm or more at measurement point (ϕ15 mm) on main surface of epitaxial layer of epitaxial layer-attached GaAs substrate (defects) | Device yield (%) |
|---|---|---|---|
| P1 | 0 | 29 | 94 |
| P2 | 1 | 39 | 95 |
| P3 | 1 | 66 | 89 |
| P4 | 2 | 55 | 95 |
| P5 | 0 | 13 | 95 |
| P6 | 1 | 48 | 91 |
| P7 | 2 | 70 | 85 |
| P8 | 1 | 70 | 90 |
| P9 | 0 | 52 | 89 |
| Average | 0.9 | - | - |
| σ | 0.8 | - | - |
| σ/average | 0.89 | - | - |

### [Example 12: Si (Silicon)-doped GaAs Substrate (ϕ200 mm)]

### <Preparation of Group III-V Compound Semiconductor Single Crystal Substrate (GaAs Substrate)>

A GaAs substrate of Example 12 was prepared in the same manner as was the GaAs substrate of Example 9, except that a GaAs substrate precursor having a diameter of 200 mm (8 inches) having a main surface having a plane orientation of the {100} just plane was prepared in the preparing step.

### <Measurement of First Particles on Main Surface of GaAs Substrate>

In the GaAs substrate of Example 12, the density of the first particles and the standard deviation/average value of the number of the first particles at measurement points P1 to P9 were each determined in the same manner as the measurement carried out in the GaAs substrate of Comparative Example 4.

The density of the first particles in the GaAs substrate of Example 12 was 2.7 /cm². The standard deviation/average value of the number of the first particles at measurement points P1 to P9 in the GaAs substrate of Example 12 is shown in Table 19.

### <Formation of Epitaxial Layer and Measurement of LPD>

An epitaxial layer-attached GaAs substrate of Example 12 was prepared in the same manner as was the epitaxial layer-attached GaAs substrate of Comparative Example 4. Furthermore, in the epitaxial layer-attached GaAs substrate of Example 12, the number of LPDs having a circle-equivalent diameter of 0.136 µm or more at measurement points corresponding to measurement points P1 to P9 was determined in the same manner as in the measurement carried out in the epitaxial layer-attached GaAs substrate of Comparative Example 4. The results are shown in Table 19. Table 19 also shows the device yield (%) of 100 devices each manufactured from a region including measurement points P1 to P9 on the substrate.

### [Table 19]

**Table. 19**

| Measurement point | Number of particles having particle size of 0.079 µm or more at measurement point (<p15 mm) on main surface of GaAs substrate (particles) | Number of LPDs having circle-equivalent diameter of 0.136 µm or more at measurement point (ϕ15 mm) on main surface of epitaxial layer of epitaxial layer-attached GaAs substrate (defects) | Device yield (%) |
|---|---|---|---|
| P1 | 2 | 29 | 94 |
| P2 | 3 | 24 | 95 |
| P3 | 2 | 4 | 94 |
| P4 | 5 | 134 | 86 |
| P5 | 4 | 152 | 82 |
| P6 | 5 | 89 | 91 |
| P7 | 9 | 150 | 98 |
| P8 | 8 | 198 | 78 |
| P9 | 5 | 144 | 89 |
| Average | 4.8 | - | - |
| σ | 2.4 | - | - |
| σ/average | 0.50 | - | - |

### [Discussion]

According to Tables 1 to 19, in each of the group III-V compound semiconductor single crystal substrates of Example 1 to Example 12, the density of the first particles (particles having a particle size of 0.079 µm or more) on the main surface was 0 /cm² or more and 13.0 /cm² or less, and the standard deviation/average value of the number of the first particles measured at measurement points P1 to P9 at the nine points satisfied the relationship of standard deviation/average value ≤ 0.9. Furthermore, in each of the group III-V compound semiconductor single crystal substrates (indium phosphide single crystal substrates) of Example 1 to Example 8, the density of the second particles (particles having a particle size of 0.19 µm or more) on the main surface was 0 /cm² or more and 0.62 /cm² or less, and the standard deviation/average value of the number of the second particles measured at measurement points P1 to P9 at the nine points satisfied the relationship of standard deviation/average value ≤ 1.25.

On the other hand, each of the group III-V compound semiconductor single crystal substrates of Comparative Example 1 to Comparative Example 7 did not satisfy at least one of the condition of the density of the first particles on the main surface being 0 /cm² or more and 13.0 /cm² or less or the condition of the standard deviation/average value of the number of the first particles measured at measurement points P1 to P9 at the nine points being the standard deviation/average value ≤ 0.9. Furthermore, each of the group III-V compound semiconductor single crystal substrates (indium phosphide single crystal substrate) of Comparative Example 1 to Comparative Example 3 did not satisfy at least one of the condition of the density of the second particles on the main surface being 0 /cm² or more and 0.62 /cm² or less or the condition of the standard deviation/average value of the number of the second particles measured at measurement points P1 to P9 at the nine points being the standard deviation/average value ≤ 1.25.

Especially, it was observed that in the group III-V compound semiconductor single crystal substrates of Example 1 to Example 12, the device yield tended to be higher than in the group III-V compound semiconductor single crystal substrates of Comparative Example 1 to Comparative Example 7, suggesting that it would be possible to provide a high-performance semiconductor device.

The embodiments and the Examples of the present disclosure have been described as above, and it is also planned from the beginning to appropriately combine the configurations of the embodiments and the Examples described above.

The embodiments and the Examples disclosed herein should be considered in all respects illustrative and not restrictive. The scope of the present invention is defined not by the embodiments and the Examples mentioned above, but by the claims, and intended to encompass meanings equivalent to the claims, and all changes within the scope.

### REFERENCE SIGNS LIST

100 Group III-V compound semiconductor single crystal substrate; 10 Main surface; 20 First region; 21 First reference line; 22 First virtual line; P1, P2, P3, P4, P5, P6, P7, P8, P9 Measurement point; OF Orientation flat; N Notch; S10 Preparing step; S20 Polishing step; S30 Cleaning step; S31 Liquid phase treating step; S311 Rough cleaning step; S312 Precision cleaning step; S32 Vapor phase treating step; S33 Oxide film removing step.

## Claims

1. A group III-V compound semiconductor single crystal substrate having a circular main surface, wherein
the main surface has an orientation flat or a notch;
the main surface has a first region that is a circular region inside a first virtual line passing through a point 5 mm away inward from an outer periphery thereof, and a first reference line that is a virtual line segment extending from a center of the main surface to the first virtual line in a direction going from the center of the main surface toward the orientation flat or the notch;
on the main surface,
the number of particles having a particle size of 0.079 µm or more at each of measurement points at nine points in total is measured, where the nine points are
one point at the center,
four midpoints of four virtual line segments having angles of 0 degrees, 90 degrees, 180 degrees, and 270 degrees, respectively, with respect to the first reference line and extending from the center to the first virtual line, and
four endpoints of four virtual line segments having angles of 45 degrees, 135 degrees, 225 degrees, and 315 degrees, respectively, with respect to the first reference line and extending from the center to the first virtual line, and
a standard deviation and an average value of the number of the particles calculated based on measurement results thereof satisfy a relationship of standard deviation/average value ≤ 0.9; and
in the first region, a density of the particles having a particle size of 0.079 µm or more is 0 /cm² or more and 13.0 /cm² or less.

2. A group III-V compound semiconductor single crystal substrate having a circular main surface, wherein
the group III-V compound semiconductor single crystal substrate is an indium phosphide single crystal substrate;
the main surface has an orientation flat or a notch;
the main surface has a first region that is a circular region inside a first virtual line passing through a point 5 mm away inward from an outer periphery thereof, and a first reference line that is a virtual line segment extending from a center of the main surface to the first virtual line in a direction going from the center of the main surface toward the orientation flat or the notch;
on the main surface,
the number of particles having a particle size of 0.19 µm or more at each of measurement points at nine points in total is measured, where the nine points are
one point at the center,
four midpoints of four virtual line segments having angles of 0 degrees, 90 degrees, 180 degrees, and 270 degrees, respectively, with respect to the first reference line and extending from the center to the first virtual line, and
four endpoints of four virtual line segments having angles of 45 degrees, 135 degrees, 225 degrees, and 315 degrees, respectively, with respect to the first reference line and extending from the center to the first virtual line, and
a standard deviation and an average value of the number of the particles calculated based on measurement results thereof satisfy a relationship of standard deviation/average value ≤ 1.25; and
in the first region, a density of the particles having a particle size of 0.19 µm or more is 0 /cm² or more and 0.62 /cm² or less.

3. The group III-V compound semiconductor single crystal substrate according to claim 1, wherein the group III-V compound semiconductor single crystal substrate is an indium phosphide single crystal substrate.

4. The group III-V compound semiconductor single crystal substrate according to claim 3, wherein
in the indium phosphide single crystal substrate, the standard deviation and the average value of the number of the particles having a particle size of 0.079 µm or more satisfy a relationship of 0.23 ≤ standard deviation/average value ≤ 0.71, and
the density of the particles having a particle size of 0.079 µm or more is 2.2 /cm² or more and 12.3 /cm² or less.

5. The group III-V compound semiconductor single crystal substrate according to any one of claim 2 to claim 4, wherein in the indium phosphide single crystal substrate, a diameter of the main surface is 75 mm or more and 155 mm or less.

6. The group III-V compound semiconductor single crystal substrate according to claim 1, wherein the group III-V compound semiconductor single crystal substrate is a gallium arsenide single crystal substrate.

7. The group III-V compound semiconductor single crystal substrate according to claim 6, wherein
in the gallium arsenide single crystal substrate, the standard deviation and the average value of the number of the particles having a particle size of 0.079 µm or more satisfy a relationship of 0.5 ≤ standard deviation/average value ≤ 0.89, and
the density of the particles having a particle size of 0.079 µm or more is 0.5 /cm² or more and 2.7 /cm² or less.

8. The group III-V compound semiconductor single crystal substrate according to claim 6 or claim 7, wherein in the gallium arsenide single crystal substrate, a diameter of the main surface is 75 mm or more and 205 mm or less.

9. A method for manufacturing a group III-V compound semiconductor single crystal substrate, the method comprising
a cleaning step for obtaining a group III-V compound semiconductor single crystal substrate having a circular main surface from a group III-V compound semiconductor single crystal substrate precursor, wherein
the cleaning step comprises following steps in order of
a liquid phase treating step of cleaning the group III-V compound semiconductor single crystal substrate precursor with a liquid phase,
a vapor phase treating step of cleaning the group III-V compound semiconductor single crystal substrate precursor with a vapor phase, and
an oxide film removing step of removing an oxide film attached to the group III-V compound semiconductor single crystal substrate precursor,
the vapor phase treating step comprises irradiating the group III-V compound semiconductor single crystal substrate precursor with ultraviolet radiation in an ozone atmosphere or in an oxygen-containing atmosphere, and
the oxide film removing step comprises removing the oxide film with a first solution comprising hydrofluoric acid at 0.1% by mass or more.

10. The method for manufacturing a group III-V compound semiconductor single crystal substrate according to claim 9, wherein the first solution further comprises ammonium fluoride.

11. The method for manufacturing a group III-V compound semiconductor single crystal substrate according to claim 9 or claim 10, wherein the irradiating with ultraviolet radiation is carried out under conditions of 25°C or more and 150°C or less and 1 minute or more and 60 minutes or less.

12. The method for manufacturing a group III-V compound semiconductor single crystal substrate according to any one of claim 9 to claim 11, wherein the group III-V compound semiconductor single crystal substrate is an indium phosphide single crystal substrate.

13. The method for manufacturing a group III-V compound semiconductor single crystal substrate according to any one of claim 9 to claim 11, wherein the group III-V compound semiconductor single crystal substrate is a gallium arsenide single crystal substrate.
